# EUROPEAN PATENT APPLICATION

(11) **EP 4 633 339 A1**
(43) Date of publication of application: **15.10.2025**
(21) Application number: 25166621.0
(22) Date of filing: 27.03.2025
(51) Int. Cl.: H10K 59/121, H10K 59/122, H10K 59/124

(54) **DISPLAY DEVICE AND METHOD OF MANUFACTURING THE SAME**

(30) Priority: 12.04.2024 KR 20240049304
(71) Applicant: Samsung Display Co., Ltd., Yongin-si, Gyeonggi-do 17113 (KR)
(72) Inventor: YUN, Jonghyun, 17113 Giheung-gu, Yongin-si, Gyeonggi-do (KR); KANG, Hyunwoo, 17113 Giheung-gu, Yongin-si, Gyeonggi-do (KR); KWEON, Dae-Gi, 17113 Giheung-gu, Yongin-si, Gyeonggi-do (KR); KIM, Junyoung, 17113 Giheung-gu, Yongin-si, Gyeonggi-do (KR); PARK, Jina, 17113 Giheung-gu, Yongin-si, Gyeonggi-do (KR); YANG, Yongho, 17113 Giheung-gu, Yongin-si, Gyeonggi-do (KR); LEE, Kyung-Min, 17113 Giheung-gu, Yongin-si, Gyeonggi-do (KR); JEONG, Chang-Ho, 17113 Giheung-gu, Yongin-si, Gyeonggi-do (KR)
(74) Representative: Dr. Weitzel & Partner

(57) **Abstract**

A display device includes a substrate including an auxiliary pixel area, and a transmitting area spaced from the auxiliary pixel area, a driving element above the substrate, an insulating layer above the driving element, an electrode in the auxiliary pixel area, above the insulating layer, and electrically connected to the driving element, and a pixel-defining layer above the insulating layer, defining an opening in the auxiliary pixel area, defining a transmitting part in the transmitting area, and defining a second cutout portion spaced from the auxiliary pixel area and the transmitting area in plan view.

## Description

### BACKGROUND

### 1. Field

The present invention relates to a display device for providing visual information, and a method of manufacturing the same.

### 2. Description of the Related Art

A display device is a device that displays an image for providing visual information to a user. Among display devices, an organic light-emitting diode display device has recently attracted attention.

The organic light-emitting display device may include a pixel-defining layer. The pixel-defining layer may define an opening, and a pixel electrode may be located in the opening. That is, the pixel-defining layer may define an auxiliary pixel area in which the pixel electrode is located. In addition, the pixel-defining layer may define a transmitting part. Light and/or sound may be transmitted through the transmitting part.

### SUMMARY

The present invention is defined by the features of the independent claims. Further embodiments are disclosed in the dependent claims and in the present description. The present invention provides a display device with improved quality.

The present invention also provides a method of manufacturing the display device.

A display device according to one or more embodiments includes a substrate including an auxiliary pixel area, and a transmitting area spaced from the auxiliary pixel area, a driving element above the substrate, an insulating layer above the driving element, an electrode in the auxiliary pixel area, above the insulating layer, and electrically connected to the driving element, and a pixel-defining layer above the insulating layer, defining an opening in the auxiliary pixel area, defining a transmitting part in the transmitting area, and defining a pixel-defining layer cutout portion spaced from the auxiliary pixel area and the transmitting area in plan view. The pixel-defining layer cutout portion is also referred to as a second cutout portion in the present disclosure.

The second cutout portion may correspond to a portion of the pixel-defining layer removed from an upper surface thereof.

The second cutout portion may surround at least a portion of the transmitting part in plan view.

The insulating layer may define an insulating layer cutout portion spaced from the auxiliary pixel area and the transmitting area in plan view, wherein the pixel-defining layer fills at least a portion of the insulating layer cutout portion. The insulating layer cutout portion is also referred to as a first cutout portion in the present disclosure.

The first cutout portion may at least partially overlap the second cutout portion in plan view.

The first cutout portion may surround at least a portion of the transmitting part in plan view.

The first cutout portion may correspond to a portion of the insulating layer removed from an upper surface thereof.

The pixel-defining layer may include a flat part above the insulating layer, and a protrusion part protruding in a thickness direction from an upper surface of the flat part adjacent to the transmitting part.

The second cutout portion may be defined in the protrusion part.

The second cutout portion may be defined in the flat part.

The pixel-defining layer may include a flat part above the insulating layer, and a protrusion part protruding in a thickness direction from an upper surface of the flat part adjacent to the opening. The flat part is also referred to as a pixel-defining layer flat part and as a second flat part in the present disclosure, and the protrusion part is also referred to as a pixel-defining layer protrusion part and as a second protrusion part in the present disclosure.

A thickness of a portion of the pixel-defining layer spaced from the second cutout portion in plan view from an upper surface of the insulating layer may be greater than a thickness of a portion of the pixel-defining layer overlapping the second cutout portion from the upper surface of the insulating layer.

A display device according to one or more embodiments includes a substrate including an auxiliary pixel area, and a transmitting area spaced from the auxiliary pixel area, a driving element above the substrate, an insulating layer including an insulating layer flat part above the driving element, and an insulating layer protrusion part protruding in a thickness direction from an upper surface of the insulating layer flat part in the transmitting area, an electrode in the auxiliary pixel area above the insulating layer, and electrically connected to the driving element, and a pixel-defining layer above the insulating layer, defining an opening in the auxiliary pixel area, and defining a transmitting part in the transmitting area. The insulating layer flat part is also referred to as a first flat part in the present disclosure, and the insulating layer protrusion part is also referred to as a first protrusion part in the present disclosure.

The pixel-defining layer may define a cutout portion, that is a pixel-defining layer cutout portion, spaced from the auxiliary pixel area and the transmitting area in plan view.

A thickness of a portion of the pixel-defining layer spaced from the cutout portion in plan view from an upper surface of the insulating layer may be greater than a thickness of a portion of the pixel-defining layer overlapping the cutout portion from the upper surface of the insulating layer.

The cutout portion may surround at least a portion of the transmitting part in plan view.

The insulating layer may define a cutout portion spaced from the auxiliary pixel area and the transmitting area in plan view, wherein the pixel-defining layer fills at least a portion of the cutout portion.

The cutout portion may surround at least a portion of the transmitting part in plan view.

The pixel-defining layer may include a second flat part above the insulating layer, and a second protrusion part protruding in the thickness direction from an upper surface of the second flat part adjacent to the transmitting part. As mentioned, the second flat part is also referred to as a pixel-defining layer flat part in the present disclosure, and the second protrusion part is also referred to as a pixel-defining layer protrusion part in the present disclosure.

The pixel-defining layer may include a second flat part (or pixel-defining layer flat part) above the insulating layer, and a second protrusion part (or pixel-defining layer protrusion part) protruding in the thickness direction from an upper surface of the second flat part adjacent to the opening.

A method of manufacturing a display device according to one or more embodiments includes forming a driving element above a substrate, the substrate including an auxiliary pixel area, and a transmitting area spaced from the auxiliary pixel area, forming an insulating layer above the driving element, forming a preliminary pixel-defining layer above the insulating layer, placing a first mask including a light-blocking area overlapping the transmitting area and the auxiliary pixel area above the preliminary pixel-defining layer, and forming a pixel-defining layer defining an opening in the auxiliary pixel area, defining a transmitting part in the transmitting area, and defining a second cutout portion spaced from the auxiliary pixel area and the transmitting area in plan view by exposing and developing the preliminary pixel-defining layer through the first mask.

The second cutout portion may surround at least a portion of the transmitting part in plan view.

The method may further include forming a first cutout portion spaced from the auxiliary pixel area and the transmitting area in plan view in the insulating layer.

The second cutout portion and the first cutout portion may at least partially overlap.

The second cutout portion is formed as the preliminary pixel-defining layer fills the first cutout portion.

The forming the insulating layer may include forming a flat part above the driving element, and a protrusion part protruding from an upper surface of the flat part in a thickness direction in the transmitting area.

The forming the insulating layer may include forming a preliminary insulating layer above the driving element, forming a photoresist layer above the preliminary insulating layer, and placing a second mask including a light-transmitting area, and a semi-light-transmitting area above the photoresist layer.

The light-transmitting area of the second mask may overlap the protrusion part in plan view, wherein the semi-light-transmitting area of the second mask is spaced from the protrusion part in plan view.

The second cutout portion overlaps the light-blocking area of the first mask.

A thickness of a portion of the pixel-defining layer spaced from the second cutout portion in plan view from an upper surface of the insulating layer may be greater than a thickness of a portion of the pixel-defining layer overlapping the second cutout portion from the upper surface of the insulating layer.

A display device according to one or more embodiments may include a substrate including an auxiliary pixel area, and a transmitting area spaced apart from the auxiliary pixel area, a driving element located on the substrate, an insulating layer located on the driving element, an electrode located in the auxiliary pixel area on the insulating layer and electrically connected to the driving element, and a pixel-defining layer located on the insulating layer. In addition, the pixel-defining layer may define an opening in the auxiliary pixel area, may define a transmitting part in the transmitting area, and may define a first cutout portion spaced part from each of the auxiliary pixel area and the transmitting area in a plan view.

Accordingly, when the pixel-defining layer is cured, the likelihood of the pixel-defining layer reflowing and flowing down into the transmitting part may be reduced or prevented.

### BRIEF DESCRIPTION OF THE DRAWINGS

Illustrative, non-limiting embodiments will be more clearly understood from the following detailed description in conjunction with the accompanying drawings.
FIG. 1 is a plan view illustrating a display device according to one or more embodiments.
FIG. 2 is a cross-sectional view of the display device of FIG. 1 taken along the line I-I'.
FIG. 3 is an enlarged plan view illustrating an example of an area A of FIG. 1.
FIGS. 4, 5, 6, 7, 8, 9, 10, 11, and 12 are cross-sectional views illustrating a method of manufacturing the display device of FIG. 2.
FIG. 13 is a cross-sectional view illustrating a display device according to one or more other embodiments.
FIGS. 14, 15, 16, 17, and 18 are cross-sectional views illustrating a method of manufacturing the display device of FIG. 13.
FIG. 19 is a cross-sectional view illustrating a display device according to one or more other embodiments.
FIG. 20 is a cross-sectional view illustrating a display device according to one or more other embodiments.
FIG. 21 is a cross-sectional view illustrating a display device according to one or more other embodiments.
FIG. 22 is an enlarged plan view illustrating another example of an area A of FIG. 1.

### DETAILED DESCRIPTION

Aspects of some embodiments of the present invention and methods of accomplishing the same may be understood more readily by reference to the detailed description of embodiments and the accompanying drawings. The described embodiments are provided as examples so that this disclosure will be thorough and complete, and will fully convey the aspects of the present invention to those skilled in the art. Accordingly, processes, elements, and techniques that are redundant, that are unrelated or irrelevant to the description of the embodiments, or that are not necessary to those having ordinary skill in the art for a complete understanding of the aspects of the present invention may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present invention.

A person of ordinary skill in the art would appreciate, in view of the present disclosure in its entirety, that each suitable feature of the various embodiments of the present invention may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the invention is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present invention. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the spirit and scope of the present invention. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present invention. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present invention refers to "one or more embodiments of the present invention."

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

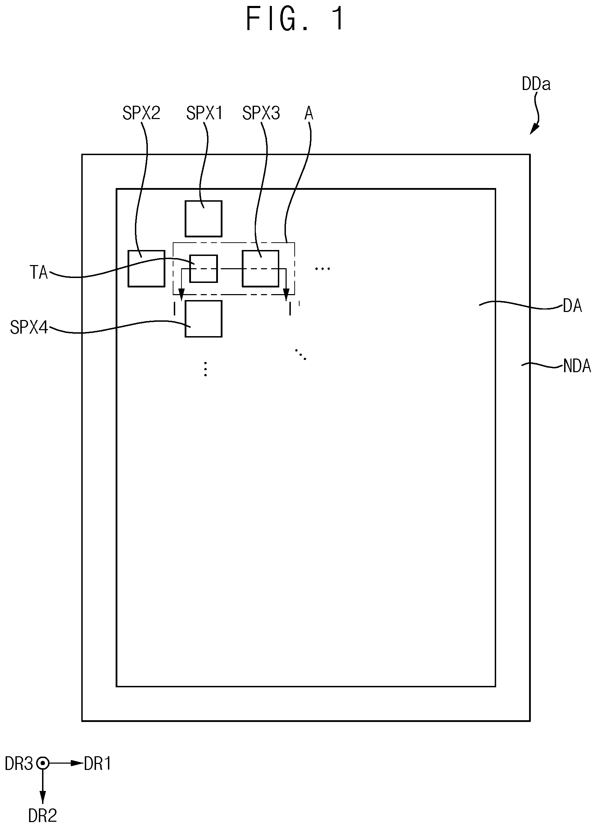

FIG. 1 is a plan view illustrating a display device according to one or more embodiments.

Referring to FIG. 1, the display device DD according to one or more embodiments may include a display area DA and a non-display area NDA.

The display area DA may be an area capable of generating light or adjusting transmittance of light provided from an external light source to display an image. The display area DA may include a plurality of auxiliary pixel areas. For example, the display area DA may include a first auxiliary pixel area SPX1, a second auxiliary pixel area SPX2, a third auxiliary pixel area SPX3, and a fourth auxiliary pixel area SPX4.

Each of the first auxiliary pixel area SPX1, the second auxiliary pixel area SPX2, the third auxiliary pixel area SPX3, and the fourth auxiliary pixel area SPX4 may mean an area in which light emitted from a light-emitting element is emitted to an outside of the display device DDa. For example, the first auxiliary pixel area SPX1 may emit first light, the second auxiliary pixel area SPX2 may emit second light, the third auxiliary pixel area SPX3 may emit third light, and the fourth auxiliary pixel area SPX4 may emit fourth light.

For example, the first light may be green light, the second light may be red light, and the third light may be blue light. However, this invention is not limited thereto. For example, the first auxiliary pixel area SPX1, the second auxiliary pixel area SPX2, and the third auxiliary pixel area SPX3 may be combined to emit yellow, cyan, and magenta light.

In one or more embodiments, the fourth auxiliary pixel region SPX4 and the first auxiliary pixel area SPX1 may emit light having substantially the same wavelength. That is, wavelength of the first light and wavelength of the fourth light may be substantially the same. However, this invention is not limited thereto. For example, the wavelength of the fourth light and wavelength of the second light may be substantially the same.

The plurality of auxiliary pixel areas may be repeatedly arranged in a first direction DR1 and a second direction DR2 crossing the first direction DR1 in the display area DA. For example, the third auxiliary pixel area SPX3 may be spaced apart from the second auxiliary pixel area SPX2 in the first direction DR1. For example, the fourth auxiliary pixel area SPX4 may be spaced apart from the first auxiliary pixel area SPX1 in the second direction DR2.

In one or more embodiments, the display area DA may further include a transmitting area TA. The transmitting area TA may be an area that does not emit light. For example, the transmitting area TA may be an area in which the plurality of auxiliary pixel areas are not located. For example, the display device DDa may include a functional module such as a camera module, a sensor module, and the like. Light and/or sound output from the camera module, the sensor module, and the like, and/or traveling from an outside toward the camera module, the sensor module, and the like, may pass through the transmitting area TA.

For example, the transmitting area TA may be located between adjacent auxiliary pixel areas. For example, the transmitting area TA may be spaced apart from the first auxiliary pixel area SPX1 in the second direction DR2, spaced apart from the second auxiliary pixel area SPX2 in the first direction DR1, spaced apart from the third auxiliary pixel area SPX3 in a direction opposite to the first direction DR1, and spaced apart from the fourth auxiliary pixel area SPX4 in a direction opposite to the second direction DR2. However, this invention is not limited thereto, and the transmitting area TA may be located at any position where the plurality of auxiliary pixel areas are not located.

The non-display area NDA may be located around the display area DA. For example, the non-display area NDA may surround at least a portion of the display area DA (e.g., in plan view). A driver may be located in the non-display area NDA. For example, the driver may include a data driver, a gate driver, and the like. The non-display area NDA may not display an image.

In one or more embodiments, the first direction DR1 and the second direction DR2 crossing the first direction DR1 may be defined. For example, the second direction DR2 may be substantially perpendicular to the first direction DR1. However, this invention is not limited thereto, and the second direction DR2 may form an acute angle or an obtuse angle with the first direction DR1. In addition, a third direction DR3 crossing a plane formed by the first direction DR1 and the second direction DR2 may be defined. For example, the third direction DR3 may be substantially perpendicular to the plane formed by the first direction DR1 and the second directions DR2. However, this invention is not limited thereto, and the third direction DR3 may form an acute angle or an obtuse angle with the plane formed by the first direction DR1 and the second direction DR2.

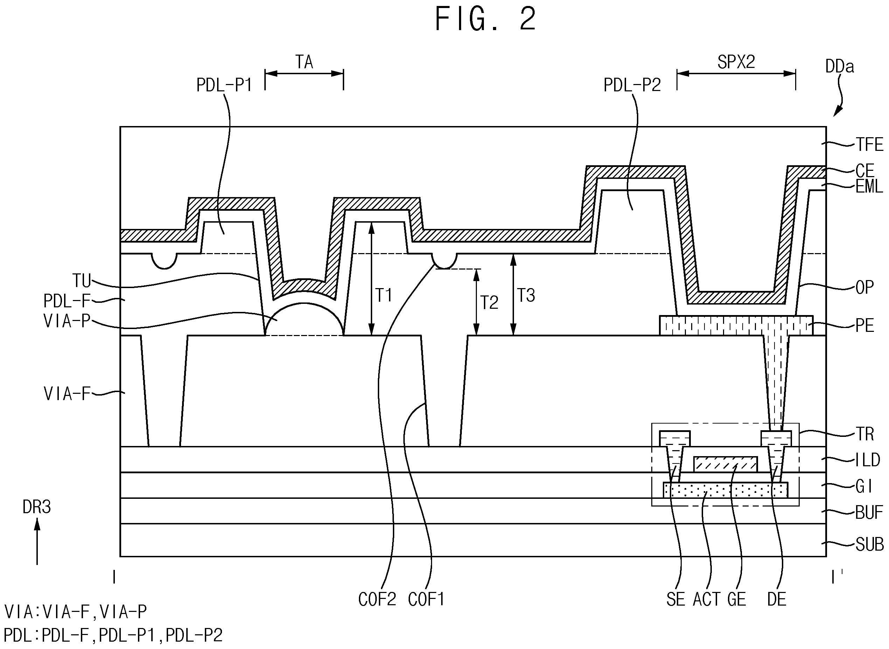

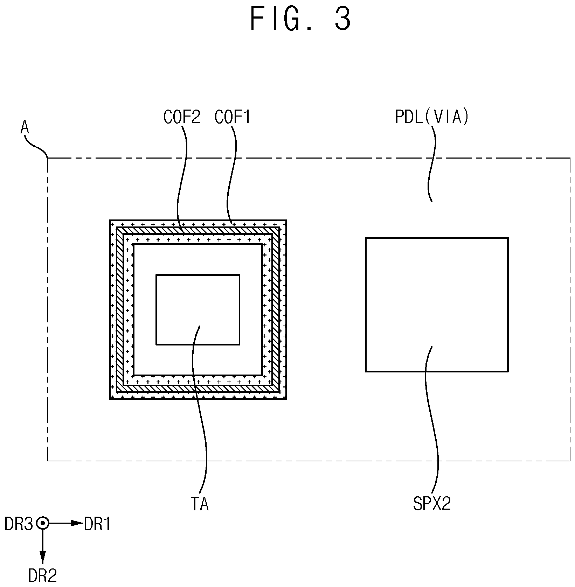

FIG. 2 is a cross-sectional view of the display device of FIG. 1 taken along the line I-I'. FIG. 3 is an enlarged plan view illustrating an example of an area A of FIG. 1.

Referring to FIGS. 1 and 2, the display device DDa according to one or more embodiments may include a substrate SUB, a driving element TR, a buffer layer BUF, a gate-insulating layer GI, an interlayer insulating layer ILD, a via insulating layer VIA, a pixel electrode PE, a light-emitting layer EML, a common electrode CE, and an encapsulation layer TFE.

As the display device DDa includes the first auxiliary pixel area SPX1, the second auxiliary pixel area SPX2, the third auxiliary pixel area SPX3, the fourth auxiliary pixel area SPX4, and the transmitting area TA, the substrate SUB may also include the first auxiliary pixel area SPX1, the second auxiliary pixel area SPX2, the third auxiliary pixel area SPX3, the fourth auxiliary pixel area SPX4, and the transmitting area TA.

The substrate SUB may include a transparent material or an opaque material. The substrate SUB may be formed of a transparent resin substrate. Example of the transparent resin substrate may include a polyimide substrate. In this case, the polyimide substrate may include a first organic layer, a first barrier layer, a second organic layer, and the like.

Alternatively, the substrate SUB may include a quartz substrate (e.g. a synthetic quartz substrate, a fluorine-doped quartz substrate), a calcium fluoride substrate, a soda lime glass substrate, a non-alkali glass substrate, or the like. These materials may be used alone or in combination with each other.

The buffer layer BUF may be located on the substrate SUB. The buffer layer BUF may reduce or prevent diffusion of metal atoms or impurities from the substrate SUB to an active pattern ACT.

For example, the buffer layer BUF may include inorganic materials, such as silicon oxide ("SiOₓ"), silicon nitride ("SiNₓ"), silicon carbide ("SiCₓ"), silicon oxynitride ("SiOₓN_{y}"), silicon oxycarbide ("SiOₓC_{y}"), or the like. These materials may be used alone or in combination with each other.

The driving element TR may include an active pattern ACT, a gate electrode GE, a source electrode SE, and a drain electrode DE.

The active pattern ACT may be located on the buffer layer BUF. The active pattern ACT may include a source area, a drain area, and a channel area located between the source area and the drain area.

The active pattern ACT may include an inorganic semiconductor (e.g., amorphous silicon, polysilicon, a metal oxide semiconductor, etc.), an organic semiconductor, or the like. These materials may be used alone or in combination with each other.

The metal oxide semiconductor may include a binary compound ("ABₓ"), a ternary compound ("ABₓC_{y}"), a quaternary compound ("ABₓC_{y}D_{z}"), or the like including indium ("In"), zinc ("Zn"), gallium ("Ga"), tin ("Sn"), titanium ("Ti"), aluminum ("AI"), hafnium ("Hf"), zirconium ("Zr"), magnesium ("Mg"), or the like. These materials may be used alone or in combination with each other.

For example, the metal oxide semiconductor may include zinc oxide ("ZnOₓ"), gallium oxide ("GaOₓ"), tin oxide ("SnOₓ"), indium oxide ("InOₓ"), indium gallium oxide ("IGO"), indium zinc oxide ("IZO"), indium tin oxide ("ITO"), indium zinc tin oxide ("IZTO"), or indium gallium zinc oxide ("IGZO"). These materials may be used alone or in combination with each other.

The gate-insulating layer GI may be located on the buffer layer BUF. The gate-insulating layer GI may sufficiently cover the active pattern ACT. For example, the gate-insulating layer GI may include an inorganic material, such as silicon oxide, silicon nitride, silicon carbide, silicon oxynitride, or silicon oxycarbide. These materials may be used alone or in combination with each other.

The gate electrode GE may be located on the gate-insulating layer GI. For example, the gate electrode GE may overlap the channel area of the active pattern ACT in a plan view.

The gate electrode GE may include a metal, an alloy, a metal nitride, a conductive metal oxide, a transparent conductive material, or the like.

Examples of the metal may include silver ("Ag"), molybdenum ("Mo"), aluminum ("Al"), tungsten ("WW"), copper ("Cu"), nickel ("Ni"), chromium ("Cr"), titanium ("Ti"), tantalum ("Ta"), platinum ("Pt"), scandium ("Sc"), or the like. These materials may be used alone or in combination with each other.

Examples of the conductive metal oxide may include Indium tin oxide, indium zinc oxide, or the like. These materials may be used alone or in combination with each other.

In addition, examples of the metal nitride may include aluminum nitride ("AINₓ"), tungsten nitride ("WNₓ"), chromium nitride ("CrNₓ"), or the like. These materials may be used alone or in combination with each other.

The interlayer insulating layer ILD may be located on the gate electrode GE. The interlayer insulating layer ILD may sufficiently cover the gate electrode GE. For example, the interlayer insulating layer ILD may include an inorganic material, such as silicon oxide, silicon nitride, silicon carbide, silicon oxynitride, silicon oxycarbide, or the like. These materials may be used alone or in combination with each other.

The source electrode SE may be located on the interlayer insulating layer ILD. The source electrode SE may be connected to the source area of the active pattern ACT through a contact hole defined by the interlayer insulating layer ILD and the gate-insulating layer GI.

The drain electrode DE may be located on the interlayer insulating layer ILD. The drain electrode DE may be connected to the drain area of the active pattern ACT through a contact hole defined by the interlayer insulating layer ILD and the gate-insulating layer GI.

Each of the source electrode SE and the drain electrode DE may include a metal, an alloy metal nitride, a conductive metal oxide, a transparent conductive material, or the like. These materials may be used alone or in combination with each other.

In one or more embodiments, the drain electrode DE and the source electrode SE may be located on the same layer. In addition, the drain electrode DE and the source electrode SE may be formed through the same process. In addition, the drain electrode DE and the source electrode SE may include substantially the same material.

The via insulating layer VIA may be located on the interlayer insulating layer ILD. The via insulating layer VIA may sufficiently cover the source electrode SE and the drain electrode DE. In one or more embodiments, the via insulating layer VIA may include a flat part VIA-F and a protrusion part VIA-P.

The flat part VIA-F of the via insulating layer VIA may be located on the driving element TR. For example, the flat part VIA-F of the via insulating layer VIA may be a part in contact with the source electrode SE and the drain electrode DE. For example, the flat part VIA-F of the via insulating layer VIA may be a part in contact with the interlayer insulating layer ILD.

The protrusion part VIA-P of the via insulating layer VIA may be a part protruding from the flat part VIA-F of the via insulating layer VIA. For example, the protrusion part VIA-P of the via insulating layer VIA may be a part protruding from an upper surface of the flat part VIA-F of the via insulating layer VIA in a thickness direction of the via insulating layer VIA. For example, the protrusion part VIA-P of the via insulating layer VIA may be a part protruding from the upper surface of the flat part VIA-F of the via insulating layer VIA in the third direction DR3.

The protrusion part VIA-P of the via insulating layer VIA may be located in at least a portion of the transmitting area TA. For example, the protrusion part VIA-P of the via insulating layer VIA may be entirely located in the transmitting area TA.

For example, the protrusion part VIA-P of the via insulating layer VIA may protrude in a semi-elliptical or parabolic shape from the flat part VIA-F of the via insulating layer VIA in a cross-sectional view. However, this invention is not limited thereto. For example, the protrusion part VIA-P of the via insulating layer VIA may protrude from the flat part VIA-F of the via insulating layer VIA in various shapes, such as a polygonal shape, a tapered shape, and an inverted tapered shape in the cross-sectional view.

In one or more embodiments, the via insulating layer VIA may define a first cutout portion COF1. For example, the flat part VIA-F of the via insulating layer VIA may define the first cutout portion COF1. The first cutout portion COF1 may be a portion in which at least a portion of the via insulating layer VIA is removed from an upper surface of the via insulating layer VIA. For example, the first cutout portion COF1 may be a portion in which at least a portion of the flat part VIA-F of the via insulating layer VIA is removed from an upper surface of the flat part VIA-F of the via insulating layer VIA.

In one or more embodiments, the first cutout portion COF1 may be a portion obtained by removing the upper surface of the flat part VIA-F of the via insulating layer VIA from an upper surface of the interlayer insulating layer ILD. That is, the first cutout portion COF1 may be a portion defined by the flat part VIA-F of the via insulating layer VIA.

Referring further to FIG. 3, the first cutout portion COF1 may be spaced apart from the second auxiliary pixel area SPX2 in the plan view. In addition, the first cutout portion COF1 may be spaced apart from the transmitting area TA in the plan view. In one or more embodiments, the first cutout portion COF1 may surround at least a portion of the transmitting area TA (e.g., in plan view). That is, the first cutout portion COF1 may surround at least a portion of the transmitting part TU to be described later in the plan view. In one or more embodiments, the first cutout portion COF1 may have a rectangular ring shape surrounding the transmitting area TA.

Referring back to FIG. 2, for example, the via insulating layer VIA may include an organic material. For example, the via insulating layer VIA may include an organic material, such as phenolic resin, polyacrylate resin, polyimide resin, polyamide resin, siloxane resin, epoxy resin, or the like. These materials may be used alone or in combination with each other. For example, the via insulating layer VIA may be referred to as an insulating layer.

The pixel electrode PE may be located on the via insulating layer VIA. The pixel electrode PE may be electrically connected to the driving element TR through a contact hole defined by the via insulating layer VIA. For example, the pixel electrode PE may be electrically connected to the drain electrode DE of the driving element TR through the contact hole defined by the via insulating layer VIA. The pixel electrode PE may be located in the second auxiliary pixel area SPX2.

The pixel electrode PE may include a metal, an alloy, a metal nitride, a conductive metal oxide, a transparent conductive material, or the like. These materials may be used alone or in combination with each other. In one or more embodiments, the pixel electrode PE may have a stacked structure including ITO/Ag/ITO. For example, the pixel electrode PE may operate as an anode. For example, the pixel electrode PE may be referred to as an electrode.

The pixel-defining layer PDL may be located on the via insulating layer VIA. The pixel-defining layer PDL may fill at least a portion of the first cutout portion COF1. For example, the pixel-defining layer PDL may entirely fill the first cutout portion COF1. In addition, the pixel-defining layer PDL may cover a side portion of the pixel electrode PE.

In one or more embodiments, the pixel-defining layer PDL may define a transmitting part TU and an opening OP. The opening OP may be located in the second auxiliary pixel area SPX2. At least a portion of an upper surface of the pixel electrode PE may be exposed through the opening OP. The transmitting part TU may be located in the transmitting area TA. At least a portion of the via insulating layer VIA may be exposed through the transmitting part TU. For example, the protrusion part VIA-P of the via insulating layer VIA may be exposed through the transmitting part TU.

In one or more embodiments, the pixel-defining layer PDL may include a flat part PDL-F, a first protrusion part PDL-P1, and a second protrusion part PDL-P2. For example, the flat part PDL-F of the pixel-defining layer PDL may be a part in contact with the pixel electrode PE. For example, the flat part PDL-F of the pixel-defining layer PDL may be a part that is located on the via insulating layer VIA and is in contact with the via insulating layer VIA.

The first protrusion part PDL-P1 of the pixel-defining layer PDL may be a part protruding from an upper surface of the flat part PDL-F of the pixel-defining layer PDL in a thickness direction of the pixel-defining layer PDL. For example, the first protrusion part PDL-P1 of the pixel-defining layer PDL may be a part protruding in the thickness direction of the pixel-defining layer PDL from the upper surface of the flat part PDL-F of the pixel-defining layer PDL adjacent to the transmitting part TU. For example, the first protrusion part PDL-P1 of the pixel-defining layer PDL may be a part protruding in the third direction DR3 from the upper surface of the flat part PDL-F of the pixel-defining layer PDL adjacent to the transmitting part TU. In one or more embodiments, the first protrusion part PDL-P1 of the pixel-defining layer PDL may surround at least a portion of the transmitting part TU in the plan view.

The second protrusion part PDL-P2 of the pixel-defining layer PDL may be a part protruding from the upper surface of the flat part PDL-F of the pixel-defining layer PDL in the thickness direction of the pixel-defining layer PDL. For example, the second protrusion part PDL-P2 of the pixel-defining layer PDL may be a part protruding in the thickness direction of the pixel-defining layer PDL from the upper surface of the flat part PDL-F of the pixel-defining layer PDL adjacent to the opening OP. For example, the second protrusion part PDL-P2 of the pixel-defining layer PDL may be a part protruding in the third direction DR3 from the upper surface of the flat part PDL-F of the pixel-defining layer PDL adjacent to the opening OP. In one or more embodiments, the second protrusion part PDL-P2 of the pixel-defining layer PDL may surround at least a portion of the opening OP in the plan view.

In one or more embodiments, an upper surface of the first protrusion part PDL-P1 of the pixel-defining layer PDL and an upper surface of the second protrusion part PDL-P2 of the pixel-defining layer PDL may be positioned at different levels. In one or more embodiments, the upper surface of the second protrusion part PDL-P2 of the pixel-defining layer PDL may be positioned at a higher level than the upper surface of the first protrusion part PDL-P1 of the pixel-defining layer PDL. This may be because the pixel electrode PE is located below the second protrusion part PDL-P2 of the pixel-defining layer PDL, or because the driving element TR is located below the second protrusion part PDL-P2 of the pixel-defining layer PDL.

However, this invention is not limited thereto, and in one or more other embodiments, the pixel-defining layer PDL may include only the flat part PDL-F. That is, the pixel-defining layer PDL may omit the first protrusion part PDL-P1 and/or the second protrusion part PDL-P2.

In one or more embodiments, the pixel-defining layer PDL may define a second cutout portion COF2. The second cutout portion COF2 may be a portion obtained by removing at least a portion of the pixel-defining layer PDL from an upper surface of the pixel-defining layer PDL.

In one or more embodiments, the flat part PDL-F of the pixel-defining layer PDL may define the second cutout portion COF2. For example, the second cutout portion COF2 may be a portion obtained by removing at least a portion of the flat part PDL-F of the pixel-defining layer PDL from the upper surface of the flat part PDL-F of the pixel-defining layer PDL.

Referring further to FIG. 3, the second cutout portion COF2 may be spaced apart from the transmitting area TA in the plan view. In addition, the second cutout portion COF2 may be spaced apart from the second auxiliary pixel area SPX2 in the plan view. In one or more embodiments, the second cutout portion COF2 may surround at least a portion of the transmitting area TA (e.g., in plan view). That is, the second cutout portion COF2 may surround at least a portion of the transmitting part TU in the plan view. In one or more embodiments, the second cutout portion COF2 may have a rectangular ring shape surrounding the transmitting area TA.

In one or more embodiments, the second cutout portion COF2 may at least partially overlap the first cutout portion COF1 in the plan view. In one or more embodiments, the second cutout portion COF2 may be located inside an area where the first cutout portion COF1 is located in the plan view. However, this invention is not limited thereto, and in one or more other embodiments, the second cutout portion COF2 may only partially overlap the first cutout portion COF1 in the plan view. That is, a portion of the second cutout portion COF2 may overlap the first cutout portion COF1 in the plan view, and another portion of the second cutout portion COF2 may not overlap the first cutout portion COF1 in the plan view.

In one or more embodiments, the second cutout portion COF2 may have a semi-elliptical shape or a parabolic shape in the cross-sectional view. The second cutout portion COF2 may have a semi-elliptical shape or a parabolic shape protruding toward the first cutout portion COF1 in the cross-sectional view, but this invention is not limited thereto, and the shape of the second cutout portion COF2 may be changed. The shape of the second cutout portion COF2 may be any shape protruding toward the first cutout portion COF1.

Referring back to FIG. 2, the pixel-defining layer PDL may have a first thickness T1 in a first portion. For example, the pixel-defining layer PDL may have the first thickness T1 in the third direction DR3 from an upper surface of the via insulating layer VIA in the first portion. The first portion of the pixel-defining layer PDL may be a portion where the flat part PDL-F of the pixel-defining layer PDL and the first protrusion part PDL-P1 of the pixel-defining layer PDL are stacked. For example, the first portion of the pixel-defining layer PDL may be spaced apart from the second cutout portion COF2 in the plan view.

The pixel-defining layer PDL may have a second thickness T2 in a second portion. For example, the pixel-defining layer PDL may have the second thickness T2 in the third direction DR3 from the upper surface of the via insulating layer VIA in the second portion. The second portion of the pixel-defining layer PDL may be a portion where the second cutout portion COF2 is located. For example, the second portion of the pixel-defining layer PDL may overlap the second cutout portion COF2 in the plan view.

The pixel-defining layer PDL may have a third thickness T3 in a third portion. For example, the pixel-defining layer PDL may have the third thickness T3 in the third direction DR3 from the upper surface of the via insulating layer VIA in the third portion. The third portion of the pixel-defining layer PDL may be a portion where the first protrusion part PDL-P1 and the second protrusion part PDL-P2 of the pixel-defining layer PDL are not located, and where only the flat part PDL-F is located. For example, the third portion of the pixel-defining layer PDL may be spaced apart from the second cutout portion COF2 in the plan view.

In one or more embodiments, the first thickness T1 may be greater than the second thickness T2. In one or more embodiments, the third thickness T3 may be greater than the second thickness T2. That is, a thickness of a portion of the pixel-defining layer PDL spaced apart from the second cutout portion COF2 in the plan view from the via insulating layer VIA may be greater than the thickness T2 of a portion of the pixel-defining layer PDL overlapping the second cutout portion COF2 in the plan view from the via insulating layer VIA.

That is, the pixel-defining layer PDL may have a smallest thickness from the upper surface of the via insulating layer VIA at a portion overlapping the second cutout portion COF2 in the plan view. As described above, the second cutout portion COF2 may overlap the first cutout portion COF1 in the plan view. When the pixel-defining layer PDL defines the second cutout portion COF2, it may mean that the pixel-defining layer PDL has a smallest thickness from the upper surface of the via insulating layer VIA at a portion overlapping the first cutout portion COF1 in the plan view. A reason why the pixel-defining layer PDL has a small thickness from a portion overlapping the first cutout portion COF1 in the plan view from the upper surface of the via insulating layer VIA may be that the pixel-defining layer PDL fills the first cutout portion COF1.

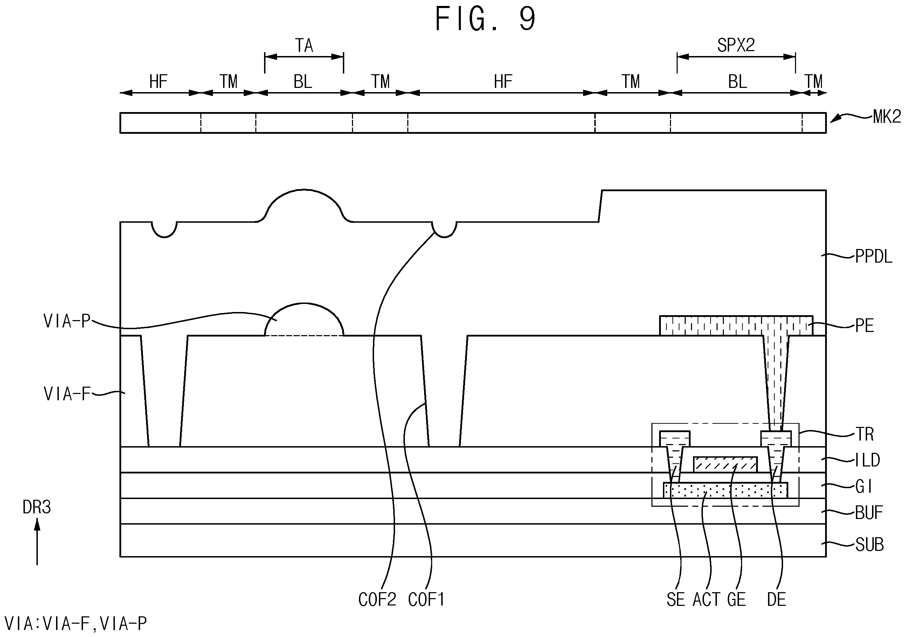

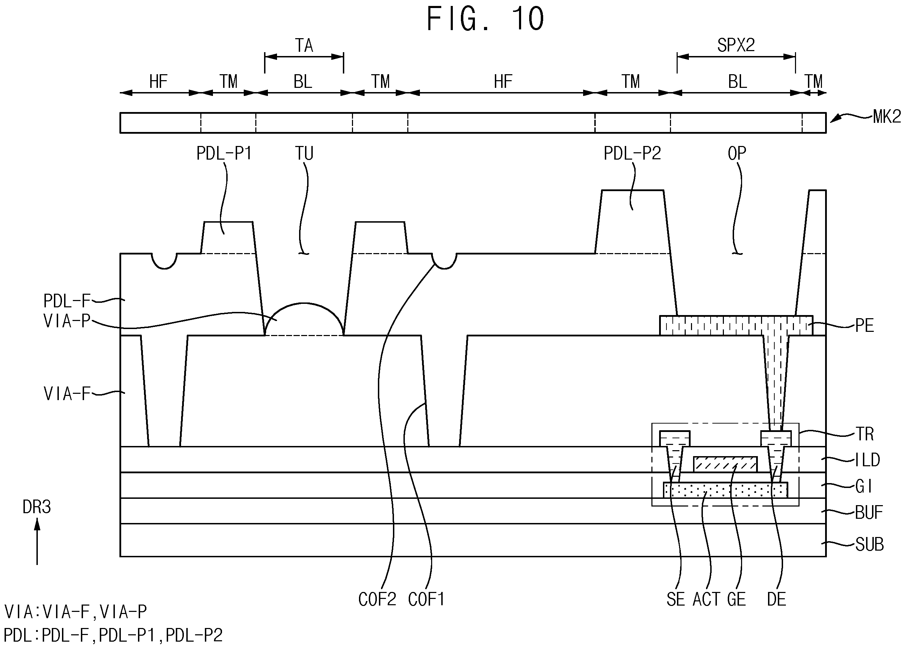

The pixel-defining layer PDL may be formed by exposing and developing a preliminary pixel-defining layer (e.g., a preliminary pixel-defining layer PPDL of FIG. 9), which will be described later with reference to FIGS. 9 and 10. In addition, after step of exposing and developing the preliminary pixel-defining layer, curing the pixel-defining layer PDL may be further performed. When the pixel-defining layer PDL is cured, the pixel-defining layer PDL may reflow and flow down into the transmitting part TU. Accordingly, an area occupied by the transmitting part TU in the pixel-defining layer PDL may be reduced. That is, the area occupied by the transmitting area TA in the pixel-defining layer PDL may be reduced.

As described above, the pixel-defining layer PDL may have the smallest thickness in a portion overlapping the first cutout portion COF1 in the plan view. That is, the pixel-defining layer PDL may have the smallest thickness in a portion where the second cutout portion COF2 is located. Accordingly, when the pixel-defining layer PDL is cured, the pixel-defining layer PDL may tend to reflow in a direction in which the second cutout portion COF2 is located. That is, when the pixel-defining layer PDL is cured, the pixel-defining layer PDL may tend to reflow into the second cutout portion COF2, rather than into the transmitting part TU. Accordingly, when the pixel-defining layer PDL is cured, the likelihood of the pixel-defining layer PDL reflowing and flowing down into the transmitting part TU may be reduced or prevented. Alternatively, when the pixel-defining layer PDL is cured, tendency of the pixel-defining layer PDL to flow down into the transmitting part TU may decrease.

In addition, as described above, the protrusion part VIA-P of the via insulating layer VIA may be located in at least a portion of the transmitting area TA. As the protrusion part VIA-P of the via insulating layer VIA is located in the transmitting area TA, when the pixel-defining layer PDL is cured, the likelihood of the pixel-defining layer PDL reflowing and flowing down into the transmitting part TU may be reduced or prevented.

For example, the pixel-defining layer PDL may include an inorganic material or an organic material. In one or more embodiments, the pixel-defining layer PDL may include an organic material. Examples of the organic material may include polyacrylic resin, polyimide resin, acrylic resin, phenol resin, or the like. These materials may be used alone or in combination with each other. In one or more embodiments, the pixel-defining layer PDL may further include a negative photosensitive material. In one or more embodiments, the pixel-defining layer PDL may further include a light-blocking material including a black pigment, a black dye, or the like.

The light-emitting layer EML may be located on the protrusion part VIA-P of the via insulating layer VIA, the pixel electrode PE, and the pixel-defining layer PDL. In one or more embodiments, the light-emitting layer EML may be continuously located over the plurality of auxiliary pixel areas and the transmitting area TA. For example, the light-emitting layer EML may be continuously located over the second auxiliary pixel area SPX2 and the transmitting area TA. However, this invention is not limited thereto, and in one or more other embodiments, the light-emitting layer EML may be located only in each of the plurality of auxiliary pixel areas. For example, the light-emitting layer EML may be located only in the second auxiliary pixel area SPX2, and may not be located in the transmitting area TA. The light-emitting layer EML may include an organic material that emits light of a corresponding color (e.g., predetermined color).

A thickness of the light-emitting layer EML may be reduced on the second protrusion part PDL-P2 of the pixel-defining layer PDL. In one or more embodiments, the second protrusion part PDL-P2 of the pixel-defining layer PDL includes a first side surface adjacent to the opening OP, and a second side surface opposite to the first side surface. A thickness of the light-emitting layer EML may be reduced on the second side surface. However, this invention is not limited thereto, and the thickness of the light-emitting layer EML may decrease on the first side surface, or may decrease on the upper surface of the second protrusion part PDL-P2 of the pixel-defining layer PDL. In addition, the thickness of the light-emitting layer EML may decrease on the first protrusion part PDL-P1 of the pixel-defining layer PDL.

A voltage may be applied to the pixel electrode PE to emit light from the second auxiliary pixel area SPX2. For example, the voltage applied to the pixel electrode PE might not affect an auxiliary pixel area adjacent to the second auxiliary pixel area SPX2. However, by the light-emitting layer EML, the voltage may be laterally conducted from the pixel electrode PE to a pixel electrode located in the auxiliary pixel area adjacent to the second auxiliary pixel area SPX2. Accordingly, a pixel cross-talk phenomenon, in which a nominally off auxiliary pixel emits light by an on auxiliary pixel adjacent to the nominally off auxiliary pixel, may occur. The pixel cross-talk phenomenon may deteriorate performance of the display device Dda, and may cause color-shift of an image. The thickness of the light-emitting layer EML may decrease on the first protrusion part PDL-P1 and the second protrusion part PDL-P2 of the pixel-defining layer PDL. Accordingly, the likelihood of a voltage being laterally conducted from the pixel electrode PE to a pixel electrode located in an auxiliary pixel area adjacent to the second auxiliary pixel area SPX2 by the light-emitting layer EML may be reduced or prevented.

The common electrode CE may be located on the light-emitting layer EML. The common electrode CE may include a metal, an alloy, a metal nitride, a conductive metal oxide, a transparent conductive material, or the like. These materials may be used alone or in combination with each other. The common electrode CE may operate as a cathode.

The encapsulation layer TFE may be located on the common electrode CE. The encapsulation layer TFE may reduce or prevent impurities, moisture, and the like penetrating into the pixel electrode PE, the light-emitting layer EML, and the common electrode CE from an outside. The encapsulation layer TFE may include at least one inorganic layer and at least one organic layer.

For example, the inorganic layer may include silicon oxide, silicon nitride, silicon oxynitride, or the like. These materials may be used alone or in combination with each other. The organic layer may include a cured polymer, such as polyacrylate.

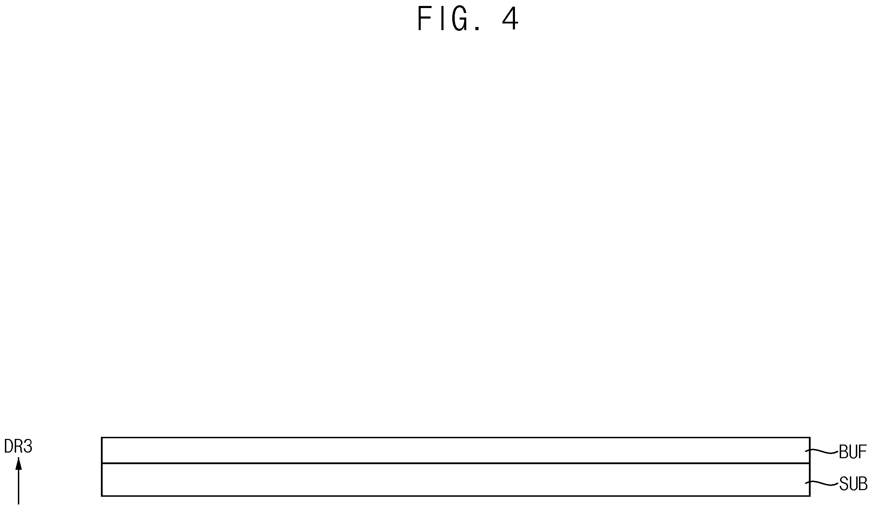

FIGS. 4, 5, 6, 7, 8, 9, 10, 11, and 12 are cross-sectional views illustrating a method of manufacturing the display device of FIG. 2.

Referring to FIG. 4, the buffer layer BUF may be formed on the substrate SUB (as used herein, "formed on" may mean "formed above"). The substrate SUB may include a transparent material or an opaque material. The substrate SUB may be formed of a transparent resin substrate. Examples of the transparent resin substrate may include a polyimide substrate. In this case, the polyimide substrate may include a first organic layer, a first barrier layer, a second organic layer, and the like.

Alternatively, the substrate SUB may include a quartz substrate (e.g. a synthetic quartz substrate, a fluorine-doped quartz substrate), a calcium fluoride substrate, a soda lime glass substrate, a non-alkali glass substrate, or the like. These materials may be used alone or in combination with each other.

For example, the buffer layer BUF may include inorganic materials, such as silicon oxide ("SiOₓ"), silicon nitride ("SiNₓ"), silicon carbide ("SiCₓ"), silicon oxynitride ("SiOₓN_{y}"), silicon oxycarbide ("SiOₓC_{y}"), or the like. These materials may be used alone or in combination with each other.

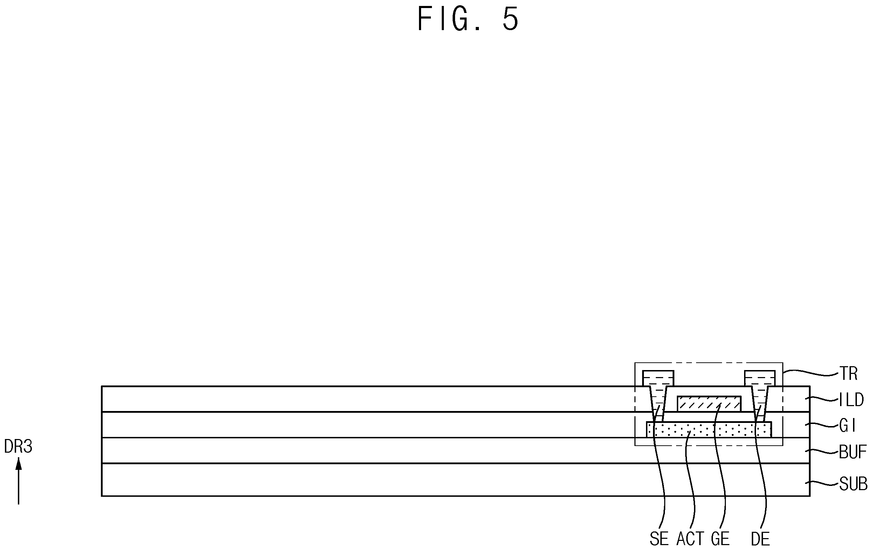

Referring to FIG. 5, the gate-insulating layer GI may be located on the buffer layer BUF (as used herein, "located on" may mean "above"). The gate-insulating layer GI may sufficiently cover the active pattern ACT. For example, the gate-insulating layer GI may include an inorganic material, such as silicon oxide, silicon nitride, silicon carbide, silicon oxynitride, or silicon oxycarbide. These materials may be used alone or in combination with each other.

The gate-insulating layer GI may be formed on the buffer layer BUF. The gate-insulating layer GI may sufficiently cover the active pattern ACT. For example, the gate-insulating layer GI may include an inorganic material, such as silicon oxide, silicon nitride, silicon carbide, silicon oxynitride, or silicon oxycarbide. These materials may be used alone or in combination with each other.

The driving element TR may be formed on the substrate SUB. For example, the active pattern ACT may be formed on the buffer layer BUF, the gate electrode GE may be formed on the gate-insulating layer GI, and the source electrode SE and the drain electrode DE may be formed on the interlayer insulating layer ILD.

The active pattern ACT may include a source area, a drain area, and a channel area located between the source area and the drain area.

The active pattern ACT may include an inorganic semiconductor (e.g., amorphous silicon, polysilicon, a metal oxide semiconductor, etc.), an organic semiconductor, or the like. These materials may be used alone or in combination with each other.

The metal oxide semiconductor may include a binary compound ("ABₓ"), a ternary compound ("ABₓC_{y}"), a quaternary compound ("AB_{X}C_{y}D_{z}"), or the like including indium ("In"), zinc ("Zn"), gallium ("Ga"), tin ("Sn"), titanium ("Ti"), aluminum ("Al"), hafnium ("Hf"), zirconium ("Zr"), magnesium ("Mg"), or the like. These materials may be used alone or in combination with each other.

For example, the metal oxide semiconductor may include zinc oxide ("ZnOₓ"), gallium oxide ("GaOₓ"), tin oxide ("SnOₓ"), indium oxide ("InOₓ"), indium gallium oxide ("IGO"), indium zinc oxide ("IZO"), indium tin oxide ("ITO"), indium zinc tin oxide ("IZTO"), or indium gallium zinc oxide ("IGZO"). These materials may be used alone or in combination with each other.

The gate electrode GE may be formed on the gate-insulating layer GI. For example, the gate electrode GE may overlap the channel area of the active pattern ACT in a plan view.

The gate electrode GE may include a metal, an alloy, a metal nitride, a conductive metal oxide, a transparent conductive material, or the like.

Examples of the metal may include silver ("Ag"), molybdenum ("Mo"), aluminum ("Al"), tungsten ("W"), copper ("Cu"), nickel ("Ni"), chromium ("Cr"), titanium ("Ti"), tantalum ("Ta"), platinum ("Pt"), scandium ("Sc"), or the like. These materials may be used alone or in combination with each other.

Examples of the conductive metal oxide may include Indium tin oxide, indium zinc oxide, or the like. These materials may be used alone or in combination with each other.

In addition, examples of the metal nitride may include aluminum nitride ("AlNₓ"), tungsten nitride ("WNₓ"), chromium nitride ("CrNₓ"), or the like. These materials may be used alone or in combination with each other.

The interlayer insulating layer ILD may be formed on the gate electrode GE. The interlayer insulating layer ILD may sufficiently cover the gate electrode GE. For example, the interlayer insulating layer ILD may include an inorganic material, such as silicon oxide, silicon nitride, silicon carbide, silicon oxynitride, silicon oxycarbide, or the like. These materials may be used alone or in combination with each other.

The source electrode SE may be formed on the interlayer insulating layer ILD. The source electrode SE may be connected to the source area of the active pattern ACT through a contact hole defined by the interlayer insulating layer ILD and the gate-insulating layer GI.

The drain electrode DE may be formed on the interlayer insulating layer ILD. The drain electrode DE may be connected to the drain area of the active pattern ACT through a contact hole defined by the interlayer insulating layer ILD and the gate-insulating layer GI.

Each of the source electrode SE and the drain electrode DE may include a metal, an alloy metal nitride, a conductive metal oxide, a transparent conductive material, or the like. These materials may be used alone or in combination with each other.

In one or more embodiments, the drain electrode DE and the source electrode SE may be located on the same layer. In addition, the drain electrode DE and the source electrode SE may be formed through the same process. In addition, the drain electrode DE and the source electrode SE may include substantially the same material.

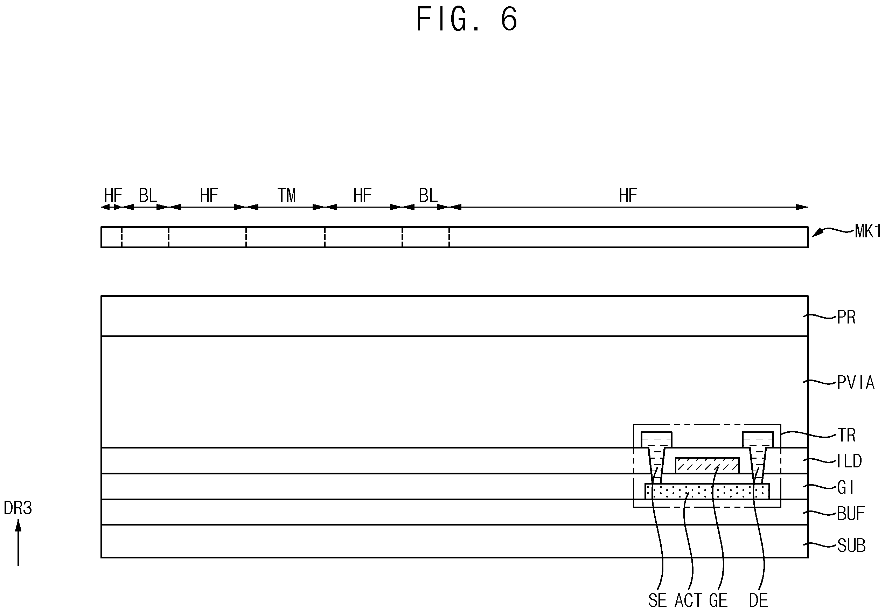

Referring to FIG. 6, a preliminary via insulating layer PVIA may be formed on the interlayer insulating layer ILD. The preliminary via insulating layer PVIA may sufficiently cover the source electrode SE and the drain electrode DE.

The preliminary via insulating layer PVIA may include an organic material. For example, the preliminary via insulating layer PVIA may include an organic material, such as phenolic resin, polyacrylate resin, polyimide resin, polyamide resin, siloxane resin, epoxy resin, or the like. These materials may be used alone or in combination with each other.

A photoresist layer PR may be formed on the preliminary via insulating layer PVIA. A first mask MK1 may be located on the photoresist layer PR. The first mask MK1 may include a semi-light-transmitting area HF, a light-blocking area BL, and a light-transmitting area TM.

The light-blocking area BL may be an area that completely blocks light from the first mask MK1 toward the photoresist layer PR. The light-transmitting area TM may be an area through which light is transmitted from the first mask MK1 to the photoresist layer PR. The semi-light-transmitting area HF may be an area through which light in an amount that is less than light transmitted through the light-transmitting area TM from the first mask MK1 toward the photoresist layer PR is transmitted.

The photoresist layer PR may be subjected to an exposure process and then a development process. Accordingly, a photoresist pattern may be formed. The preliminary via insulating layer PVIA may be etched using the photoresist pattern. The photoresist layer PR may be a positive photoresist or a negative photoresist. Hereinafter, for convenience of explanation, a case where the photoresist layer PR is a negative photoresist will be described.

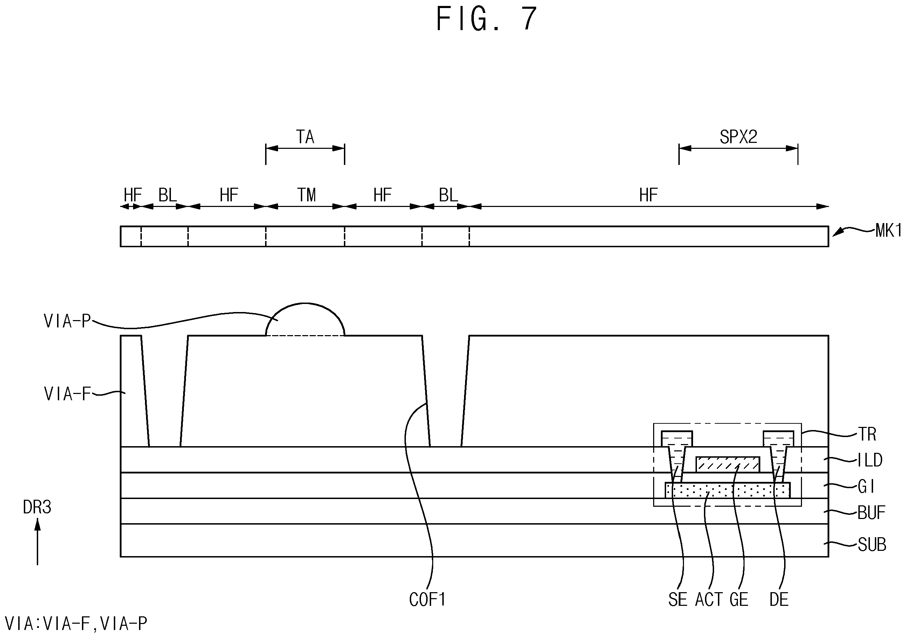

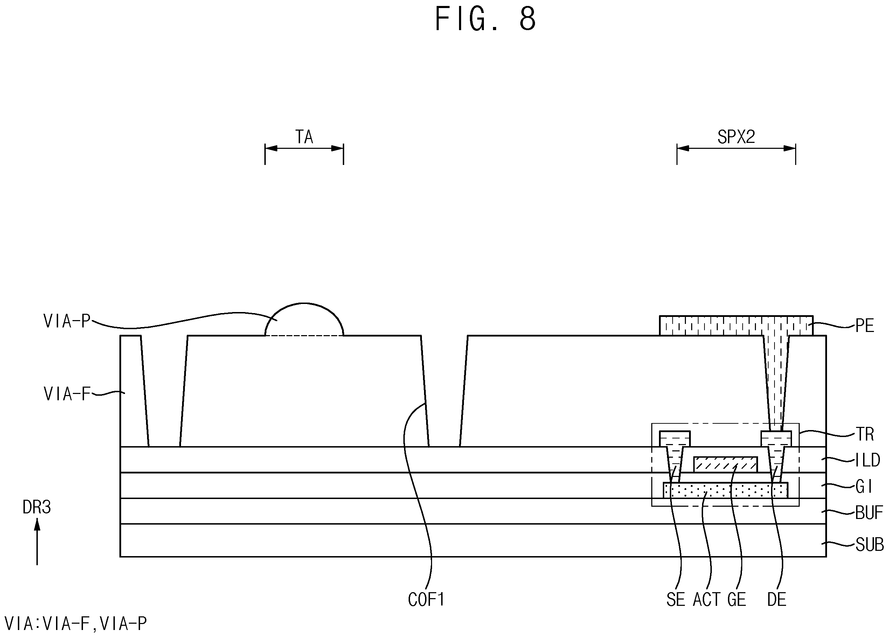

Referring to FIGS. 7 and 8, the first cutout portion COF1 may be formed in the preliminary via insulating layer PVIA. For example, the first cutout portion COF1 may be formed in a portion of the preliminary via insulating layer PVIA overlapping the light-blocking area BL of the first mask MK1 in the plan view. For example, a portion of the preliminary via insulating layer PVIA corresponding to the light-blocking area BL of the first mask MK1 may be removed by an etching process to form the first cutout portion COF1.

The flat part VIA-F of the via insulating layer VIA may be formed in a portion overlapping the semi-light-transmitting area HF of the first mask MK1 in the plan view. For example, a portion of the preliminary via insulating layer PVIA corresponding to the semi-light-transmitting area HF of the first mask MK1 remains to form the flat part VIA-F of the via insulating layer VIA.

The protrusion part VIA-P of the via insulating layer VIA may be formed in a portion overlapping the light-transmitting area TM of the first mask MK1 in the plan view. That is, the protrusion part VIA-P of the via insulating layer VIA may be formed in the transmitting area TA. For example, a portion of the preliminary via insulating layer PVIA corresponding to the light-transmitting area TM of the first mask MK1 may remain to form a protrusion part VIA-P of the via insulating layer VIA.

Referring to FIG. 8, the pixel electrode PE may be formed on the via insulating layer VIA. The pixel electrode PE may be formed in the second auxiliary pixel area SPX2. For example, the pixel electrode PE may include a metal, an alloy, a metal nitride, a conductive metal oxide, a transparent conductive material, or the like. These materials may be used alone or in combination with each other. In one or more embodiments, the pixel electrode PE may have a stacked structure including ITO/Ag/ITO.

Referring to FIG. 9, a preliminary pixel-defining layer PPDL may be formed on the via insulating layer VIA and the pixel electrode PE. The second cutout portion COF2 may be formed in the preliminary pixel-defining layer PPDL. In one or more embodiments, the second cutout portion COF2 may be formed as the first cutout portion COF1 is formed. For example, the second cutout portion COF2 may be formed as the preliminary pixel-defining layer PPDL fills the first cutout portion COF1. The formation of the second cutout portion COF2 in the preliminary pixel-defining layer PPDL may mean that the preliminary pixel-defining layer PPDL has a smallest thickness from the upper surface of the via insulating layer VIA in a portion overlapping the second cutout portion COF2 in the plan view.

For example, the preliminary pixel-defining layer PPDL may include an inorganic material or an organic material. In one or more embodiments, the preliminary pixel-defining layer PPDL may include an organic material. Examples of the organic material may include polyacrylic resin, polyimide resin, acrylic resin, phenol resin, or the like. These materials may be used alone or in combination with each other. In one or more embodiments, the preliminary pixel-defining layer PPDL may further include a negative photosensitive material. In one or more embodiments, the preliminary pixel-defining layer PPDL may further include a light-blocking material including a black pigment, a black dye, or the like.

A second mask MK2 may be located on the preliminary pixel-defining layer PPDL. The second mask MK2 may include a semi-light-transmitting area HF, a light-blocking area BL, and a light-transmitting area TM.

Referring to FIG 10, an area in which the preliminary pixel-defining layer PPDL is removed to form the opening OP and the transmitting part TU, an area in which a portion of the preliminary pixel-defining layer PPDL remains to become the flat part PDL-F of the pixel-defining layer PDL, an area in which a portion of the preliminary pixel-defining layer PPDL remains to become the first protrusion part PDL-P1 of the pixel-defining layer PDL, and an area in which a portion of the preliminary pixel-defining layer PPDL remains to become the second protrusion part PDL-P2 of the pixel-defining layer PDL, may be exposed according to different respective degrees due to the second mask MK2.

The transmitting part TU may be formed in the preliminary pixel-defining layer PPDL. For example, the transmitting part TU may be formed in a portion of the preliminary pixel-defining layer PPDL overlapping the light-blocking area BL of the second mask MK2 in the plan view. For example, the transmitting part TU may be formed in the transmitting area TA. For example, a portion of the preliminary pixel-defining layer PPDL corresponding to the light-blocking area BL of the second mask MK2 may be removed through a development process, and thus, the transmitting part TU may be formed.

The opening OP may be formed in the preliminary pixel-defining layer PPDL. For example, the opening OP may be formed in a portion of the preliminary pixel-defining layer PPDL overlapping the light-blocking area BL of the second mask MK2 in the plan view. For example, the opening OP may be formed in the second auxiliary pixel area SPX2. The opening OP may expose the upper surface of the pixel electrode PE. For example, a portion of the preliminary pixel-defining layer PPDL corresponding to the light-blocking area BL of the second mask MK2 is removed through a development, and thus, the opening OP may be formed.

The flat part PDL-F of the pixel-defining layer PDL may be formed in a portion overlapping the semi-light-transmitting area HF of the second mask MK2 in the plan view. For example, a portion of the preliminary pixel-defining layer PPDL corresponding to the semi-light-transmitting area HF of the second mask MK2 remains, and thus, the flat part PDL-F of the pixel-defining layer PDL may be formed.

The first protrusion part PDL-P1 of the pixel-defining layer PDL may be formed in a portion overlapping the light-transmitting area TM in the plan view. For example, the first protrusion part PDL-P1 of the pixel-defining layer PDL may be formed adjacent to the transmitting part TU. For example, a portion of the preliminary pixel-defining layer PPDL corresponding to the light-transmitting area TM of the second mask MK2 remains, and thus, the first protrusion part PDL-P1 of the pixel-defining layer PDL may be formed.

The second protrusion part PDL-P2 of the pixel-defining layer PDL may be formed in a portion overlapping the light-transmitting area TM in the plan view. For example, the second protrusion part PDL-P2 of the pixel-defining layer PDL may be formed adjacent to the opening OP. For example, a portion of the preliminary pixel-defining layer PPDL corresponding to the light-transmitting area TM of the second mask MK2 remains, and thus the second protrusion part PDL-P2 of the pixel-defining layer PDL may be formed.

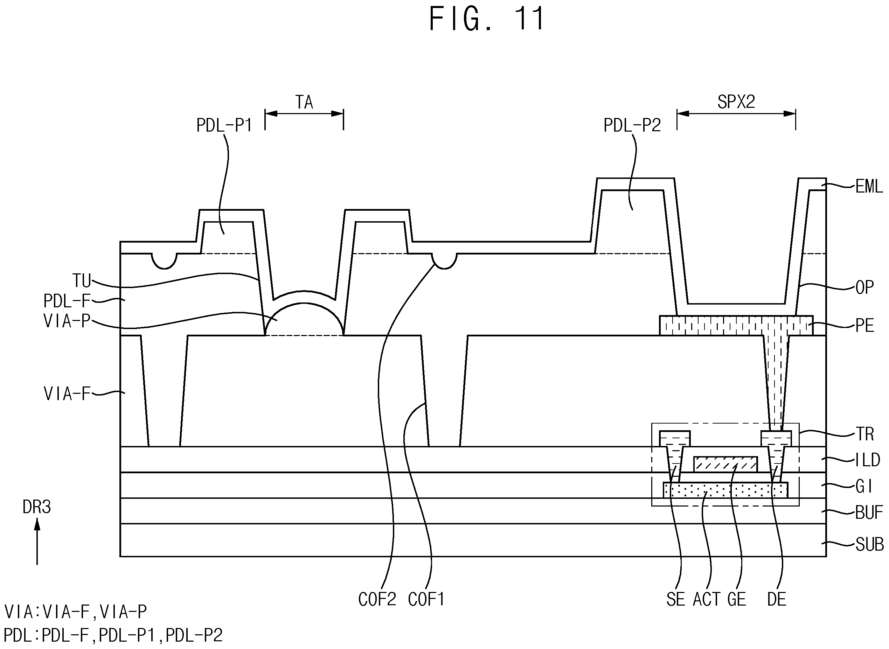

Referring to FIG. 11, the light-emitting layer EML may be formed on the protrusion part VIA-P of the via insulating layer VIA, the pixel-defining layer PDL, and the pixel electrode PE. For example, the light-emitting layer EML may include an organic material that emits light of a corresponding color (e.g., predetermined color).

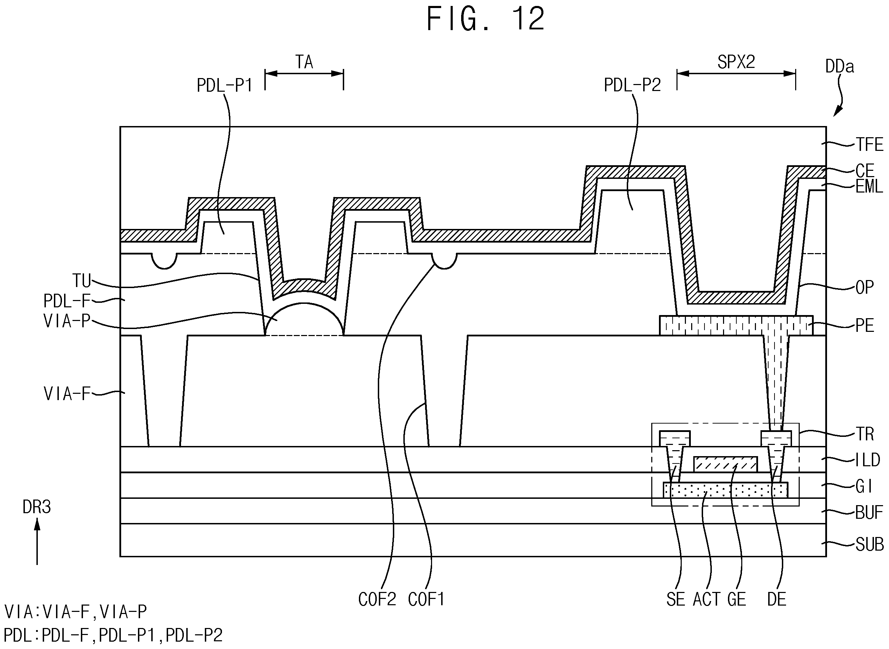

Referring to FIG. 12, the common electrode CE may be formed on the light-emitting layer EML. For example, the common electrode CE may include a metal, an alloy, a metal nitride, a conductive metal oxide, a transparent conductive material, or the like. These materials may be used alone or in combination with each other.

The encapsulation layer TFE may be formed on the common electrode CE. The encapsulation layer TFE may include at least one inorganic layer and at least one organic layer.

For example, the inorganic layer may include silicon oxide, silicon nitride, silicon oxynitride, or the like. These materials may be used alone or in combination with each other. The organic layer may include a cured polymer, such as polyacrylate.

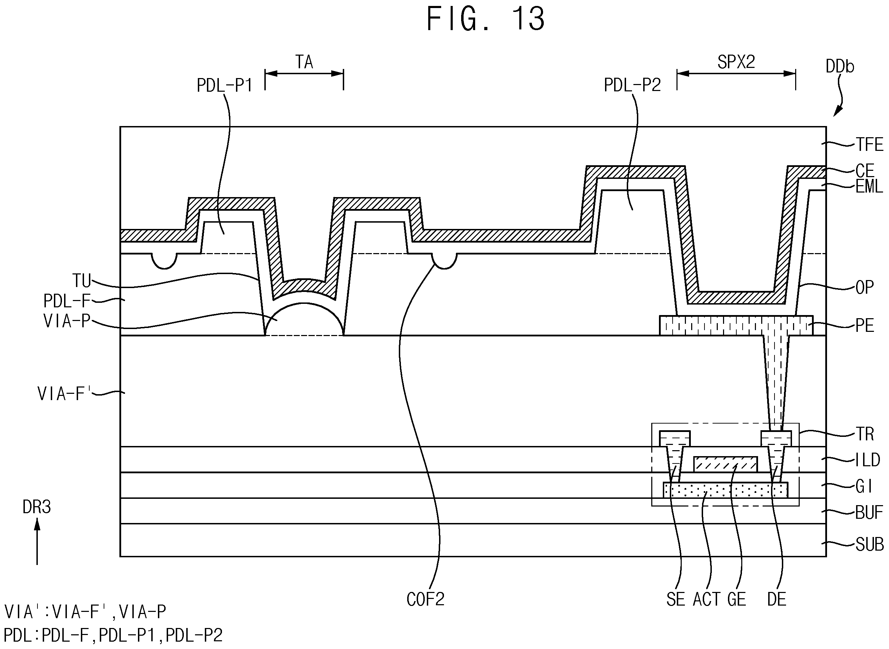

FIG. 13 is a cross-sectional view illustrating a display device according to one or more other embodiments.

A display device DDb according to one or more other embodiments described with reference to FIG. 13 may be substantially the same as or similar to the display device DDa according to one or more embodiments described with reference to FIG. 2 except for a configuration of a via insulating layer VIA'. Accordingly, overlapping or repetitive descriptions may be omitted or simplified.

Referring to FIG. 13, a via insulating layer VIA' may be located on the interlayer insulating layer ILD. The via insulating layer VIA' may include a flat part VIA-F' and a protrusion part VIA-P. The flat part VIA-F" of the via insulating layer VIA' may be located on the driving element TR. For example, the flat part VIA-F" of the via insulating layer VIA' may be a part in contact with the source electrode SE and the drain electrode DE. For example, the flat part VIA-F" of the via insulating layer VIA' may be a part in contact with the interlayer insulating layer ILD. The flat part VIA-F" of the via insulating layer VIA' may not define the first cutout part COF1 formed in the via insulating layer VIA included in the display device DDa of FIG. 2.

The protrusion part VIA-P of the via insulating layer VIA' may be a portion protruding from the flat part VIA-F" of the via insulating layer VIA'. For example, the protrusion part VIA-P of the via insulating layer VIA' may be a part protruding from an upper surface of the flat part VIA-F' of the via insulating layer VIA' in a thickness direction of the via insulating layer VIA'. For example, the protrusion part VIA-P of the via insulating layer VIA' may be a part protruding from the upper surface of the flat part VIA-F" of the via insulating layer VIA' in the third direction DR3.

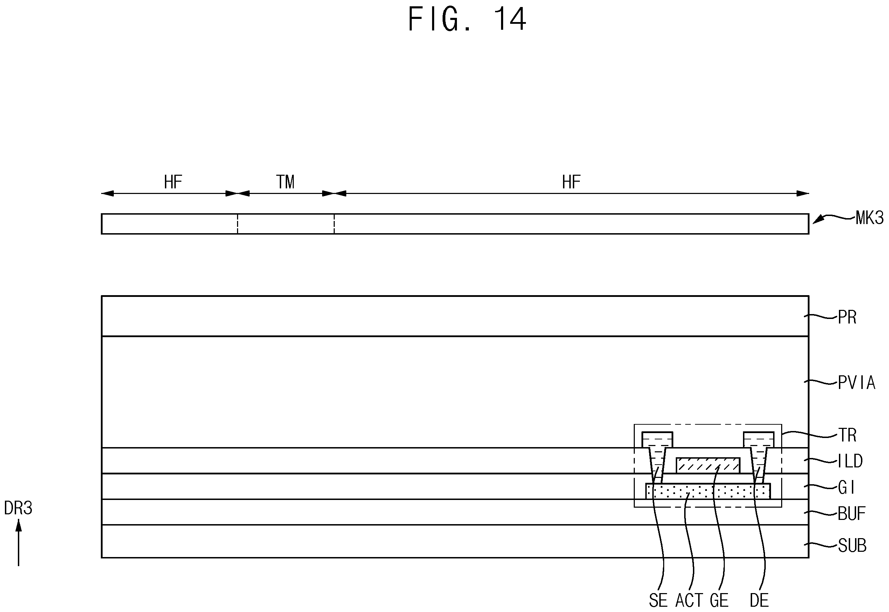

FIGS. 14, 15, 16, 17, and 18 are cross-sectional views illustrating a method of manufacturing the display device of FIG. 13.

A method of manufacturing the display device DDb described with reference to FIGS. 14, 15, 16, 17, and 18 may be substantially the same as or similar to the method of manufacturing the display device DDa described with reference to FIGS. 4, 5, 6, 7, 8, 9, 10, 11, and 12, except for a step of forming the second cutout portion COF2 through a fourth mask MK4. Accordingly, overlapping or repetitive descriptions may be omitted or simplified.

Referring to FIG. 14, the preliminary via insulating layer PVIA may be formed on the interlayer insulating layer ILD. The preliminary via insulating layer PVIA may sufficiently cover the source electrode SE and the drain electrode DE.

For example, the preliminary via insulating layer PVIA may include an organic material. For example, the preliminary via insulating layer PVIA may include an organic material, such as phenol resin, polyacrylate resin, polyimide resin, polyamide resin, siloxane resin, epoxy resin, or the like. These materials may be used alone or in combination with each other.

The photoresist layer PR may be formed on the preliminary via insulating layer PVIA. A third mask MK3 may be located on the photoresist layer PR. The third mask MK3 may include a semi-light-transmitting area HF, a light-blocking area BL, and a light-transmitting area TM.

The photoresist layer PR may be subjected to an exposure process and then a development process. Accordingly, a photoresist pattern may be formed. The preliminary via insulating layer PVIA may be etched using the photoresist pattern. The photoresist layer PR may be a positive photoresist or a negative photoresist. Hereinafter, for convenience of explanation, a case where the photoresist layer PR is a negative photoresist will be described.

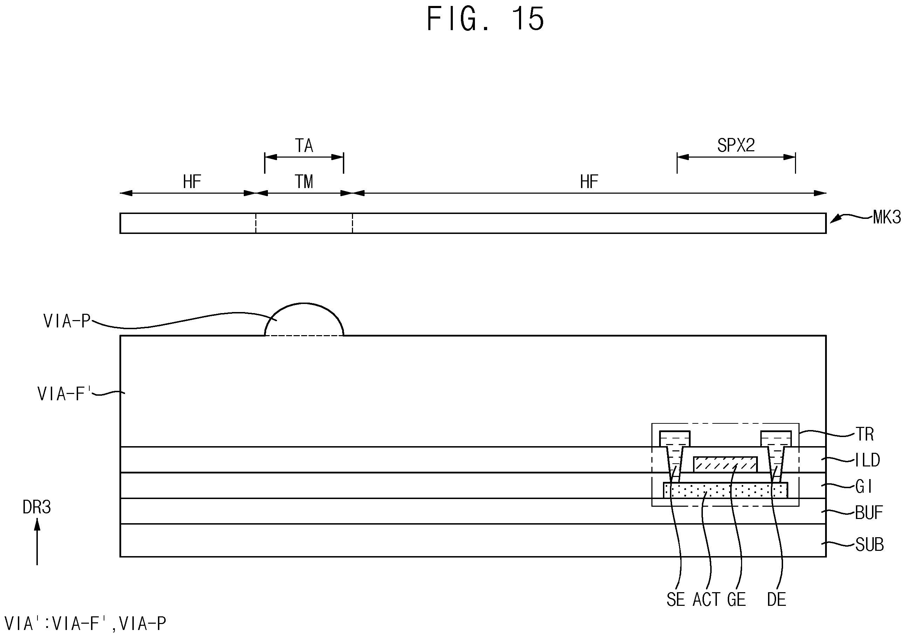

Referring to FIG. 15, the flat part VIA-F" of the via insulating layer VIA' may be formed in a portion overlapping the semi-light-transmitting area HF of the third mask MK3 in the plan view. For example, a portion of the preliminary via insulating layer PVIA corresponding to the semi-light-transmitting area HF of the third mask MK3 remains to form the flat part VIA-F" of the via insulating layer VIA'.

The protrusion part VIA-P of the via insulating layer VIA' may be formed in a portion overlapping the light-transmitting area TM of the third mask MK3 in the plan view. That is, the protrusion part VIA-P of the via insulating layer VIA' may be formed in the transmitting area TA. For example, the preliminary via insulating layer PVIA corresponding to the light-transmitting area TM of the third mask MK3 remains, and thus, the protrusion part VIA-P of the via insulating layer VIA' may be formed.

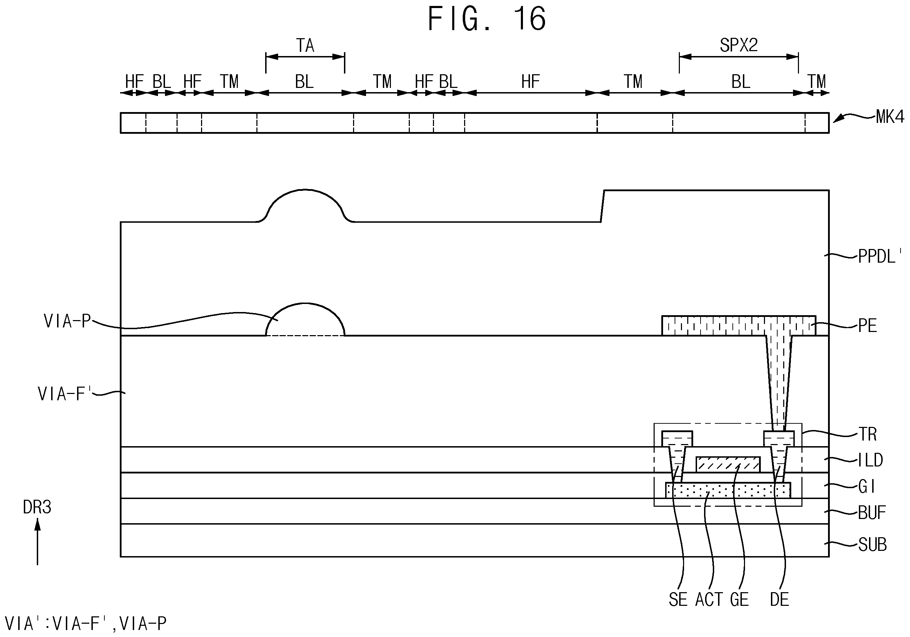

Referring to FIG. 16, the pixel electrode PE may be formed on the via insulating layer VIA'. The pixel electrode PE may be formed in the second auxiliary pixel area SPX2. For example, the pixel electrode PE may include a metal, an alloy, a metal nitride, a conductive metal oxide, a transparent conductive material, or the like. These materials may be used alone or in combination with each other. In one or more embodiments, the pixel electrode PE may have a stacked structure including ITO/Ag/ITO.

A preliminary pixel-defining layer PPDL' may be formed on the via insulating layer VIA' and the pixel electrode PE. For example, the preliminary pixel-defining layer PPDL' may include an inorganic material or an organic material. In one or more embodiments, the preliminary pixel-defining layer PPDL' may include an organic material. Examples of the organic material may include a polyacrylic resin, a polyimide resin, an acrylic resin, a phenol resin, or the like. These materials may be used alone or in combination with each other. In one or more embodiments, the preliminary pixel-defining layer PPDL' may further include a negative photosensitive material. In one or more embodiments, the preliminary pixel-defining layer PPDL' may further include a light-blocking material including a black pigment, a black dye, or the like.

A fourth mask MK4 may be located on the preliminary pixel-defining layer PPDL'. The fourth mask MK4 may include a semi-light-transmitting area HF, a light-blocking area BL, and a light-transmitting area TM.

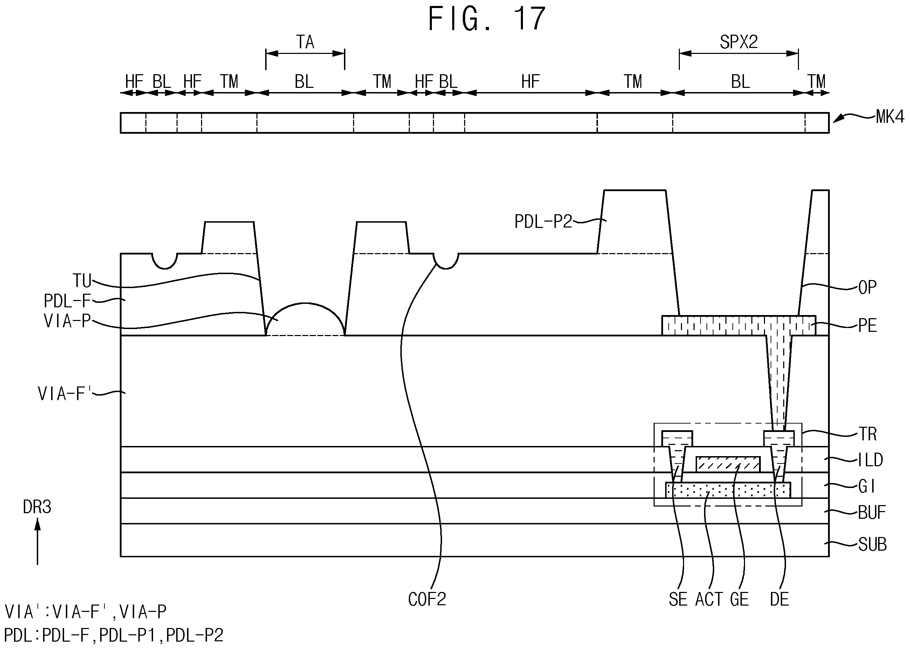

Referring to FIG. 17, an area in which a portion of the preliminary pixel-defining layer PPDL' is removed to form the opening OP and the transmitting part TU, an area in which a portion of the preliminary pixel-defining layer PPDL' is removed to form the second cutout portion COF2, an area in which a portion of the preliminary pixel-defining layer PPDL' remains to become the flat part PDL-F of the pixel-defining layer PDL, an area in which a portion of the preliminary pixel-defining layer PPDL' remains to become the first protrusion part PDL-P1 of the pixel-defining layer PDL, and an area in which a portion of the preliminary pixel-defining layer PPDL' remains to become the second protrusion part PDL-P2 of the pixel-defining layer PDL, may be exposed to different respective degrees due to the fourth mask MK4.

The transmitting part TU may be formed in the preliminary pixel-defining layer PPDL'. For example, the transmitting part TU may be formed in a portion of the preliminary pixel-defining layer PPDL' overlapping the light-blocking area BL of the fourth mask MK4 in the plan view. For example, the transmitting part TU may be formed in the transmitting area TA. For example, a portion of the preliminary pixel-defining layer PPDL' corresponding to the light-blocking area BL of the fourth mask MK4 may be removed through a development process, and thus, the transmitting part TU may be formed.

The opening OP may be formed in the preliminary pixel-defining layer PPDL'. For example, the opening OP may be formed in a portion of the preliminary pixel-defining layer PPDL' overlapping the light-blocking area BL of the fourth mask MK4 in the plan view. For example, the opening OP may be formed in the second auxiliary pixel area SPX2. The opening OP may expose the upper surface of the pixel electrode PE. For example, a portion of the preliminary pixel-defining layer PPDL' corresponding to the light-blocking area BL of the fourth mask MK4 is removed through a development, and thus, the opening OP may be formed.

The flat part PDL-F of the pixel-defining layer PDL may be formed in a portion overlapping the semi-light-transmitting area HF of the fourth mask MK4 in the plan view. For example, a portion of the preliminary pixel-defining layer PPDL' corresponding to the semi-light-transmitting area HF of the fourth mask MK4 remains, and thus, the flat part PDL-F of the pixel-defining layer PDL may be formed.

The first protrusion part PDL-P1 of the pixel-defining layer PDL may be formed in a portion overlapping the light-transmitting area TM in the plan view. For example, the first protrusion part PDL-P1 of the pixel-defining layer PDL may be formed adjacent to the transmitting part TU. For example, a portion of the preliminary pixel-defining layer PPDL' corresponding to the light-transmitting area TM of the fourth mask MK4 remains, and thus, the first protrusion part PDL-P1 of the pixel-defining layer PDL may be formed.

The second protrusion part PDL-P2 of the pixel-defining layer PDL may be formed in a portion overlapping the light-transmitting area TM in the plan view. For example, the second protrusion part PDL-P2 of the pixel-defining layer PDL may be formed adjacent to the opening OP. For example, a portion of the preliminary pixel-defining layer PPDL' corresponding to the light-transmitting area TM of the fourth mask MK4 remains, and thus, the second protrusion part PDL-P2 of the pixel-defining layer PDL may be formed.

The second cutout portion COF2 may be formed in the preliminary pixel-defining layer PPDL'. For example, the second cutout portion COF2 may be formed in a portion of the preliminary pixel-defining layer PPDL' overlapping the light-blocking area BL of the fourth mask MK4 in the plan view. For example, the second cutout portion COF2 may be formed to surround at least a portion of the transmitting part TU (e.g., in plan view). For example, the second cutout portion COF2 may be formed by removing a portion of the preliminary pixel-defining layer PPDL' corresponding to the light-blocking area BL of the fourth mask MK4 through a development.

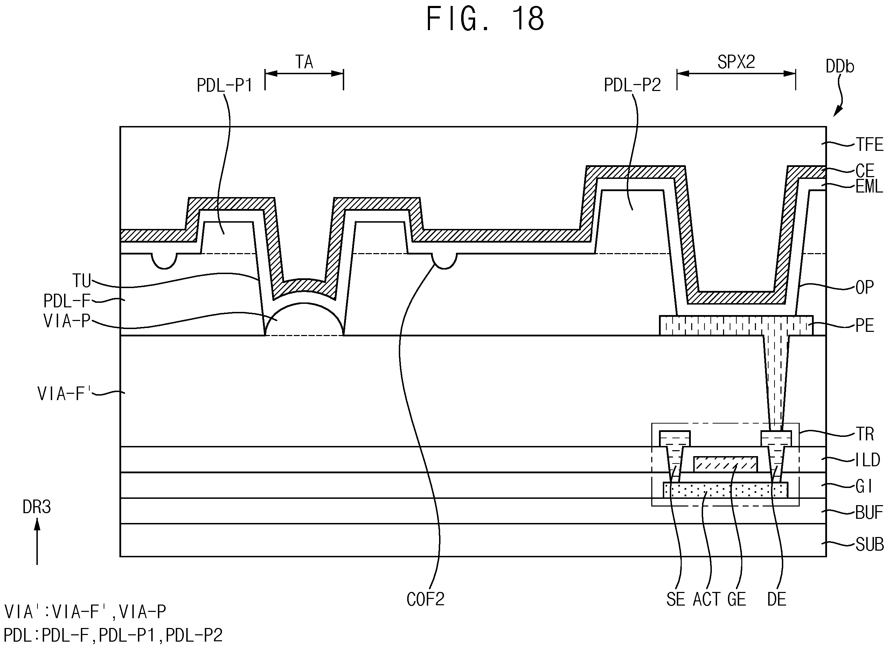

Referring to FIG. 18, the light-emitting layer EML may be formed on the protrusion part VIA-P of the via insulating layer VIA', the pixel-defining layer PDL, and the pixel electrode PE. For example, the light-emitting layer EML may include an organic material that emits light of a corresponding color (e.g., predetermined color).

The common electrode CE may be formed on the light-emitting layer EML. For example, the common electrode CE may include a metal, an alloy, a metal nitride, a conductive metal oxide, a transparent conductive material, or the like. These materials may be used alone or in combination with each other.

The encapsulation layer TFE may be formed on the common electrode CE. The encapsulation layer TFE may include at least one inorganic layer and at least one organic layer.

For example, the inorganic layer may include silicon oxide, silicon nitride, silicon oxynitride, or the like. These materials may be used alone or in combination with each other. The organic layer may include a cured polymer, such as polyacrylate.

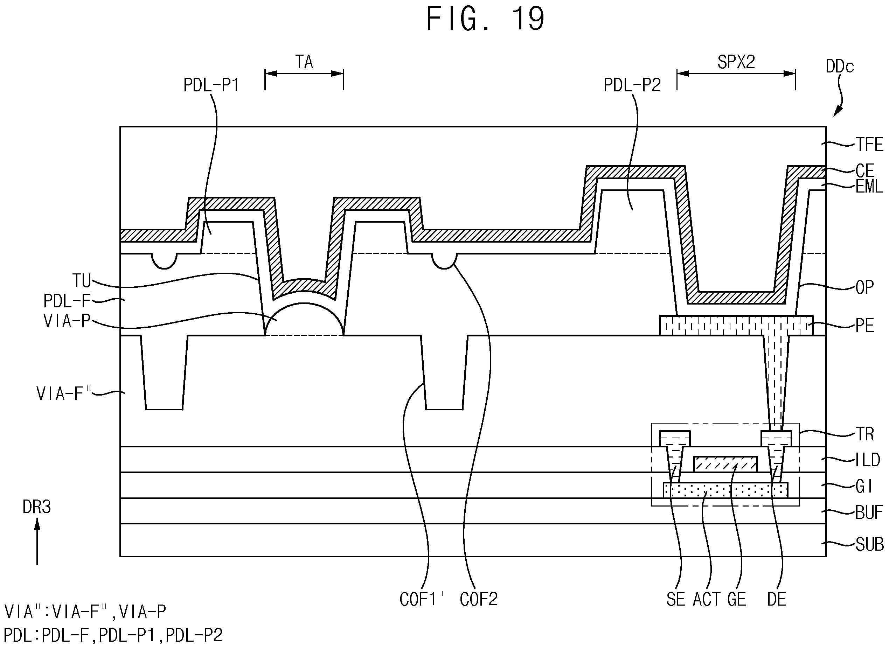

FIG. 19 is a cross-sectional view illustrating a display device according to one or more other embodiments.

A display device DDc according to one or more other embodiments described with reference to FIG. 19 may be substantially the same as or similar to the display device DDa according to one or more embodiments described with reference to FIG. 2, except for a configuration of the via insulating layer VIA". Therefore, overlapping or repetitive descriptions may be omitted or simplified.

Referring to FIG. 19, a via insulating layer VIA" may be located on the interlayer insulating layer ILD. The via insulating layer VIA" may include a flat part VIA-F" and a protruding part VIA-P. The flat part VIA-F" of the via insulating layer VIA" may be located on the driving element TR. For example, the flat part VIA-F" of the via insulating layer VIA" may be a portion in contact with the source electrode SE and the drain electrode DE. For example, the flat part VIA-F" of the via insulating layer VIA" may be a portion in contact with the interlayer insulating layer ILD.

The flat part VIA-F" of the via insulating layer VIA" may define a first cutout portion COF1'. For example, the first cutout portion COF1' may be a portion obtained by removing at least a portion of the flat part VIA-F" of the via insulating layer VIA" from an upper surface thereof.

The first cutout portion COF1' may be a portion obtained by removing only a portion of the flat part VIA-F" of the via insulating layer VIA" from the upper surface thereof. Although not illustrated in FIG. 19, as a thickness of the first cutout portion COF1' decreases in the third direction DR3, a thickness of the second cutout portion COF2 in the third direction DR3 may also decrease (e.g., the depth of the first cutout portion COF1' may corresponding to the thickness of the second cutout portion COF2).

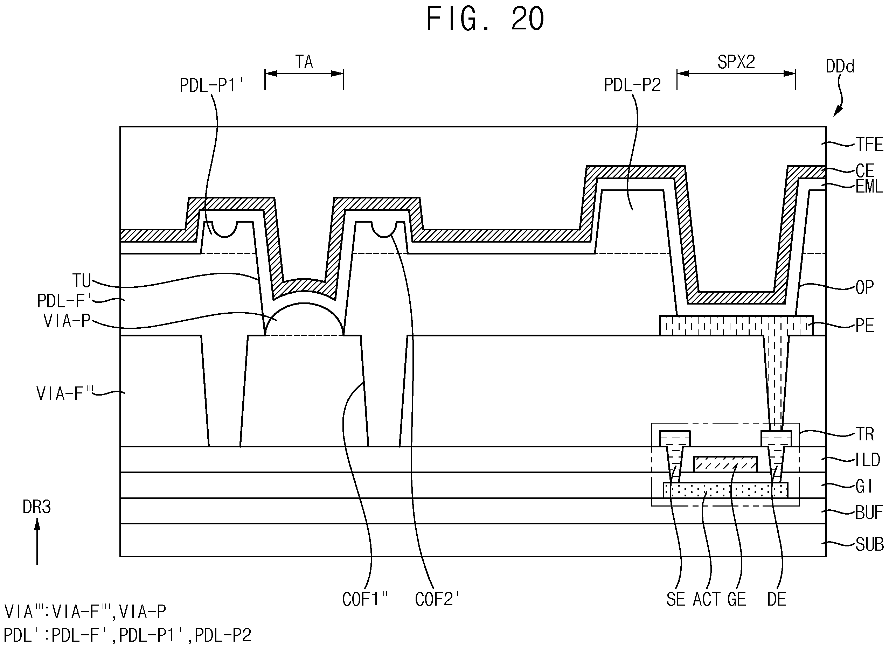

FIG. 20 is a cross-sectional view illustrating a display device according to one or more other embodiments.

A display device DDd according to one or more other embodiments described with reference to FIG. 20 may be substantially the same as, or similar to, the display device DDa according to one or more embodiments described with reference to FIG. 2, except for configurations of a via insulating layer VIA‴ and a pixel-defining layer PDL'. Therefore, overlapping or repetitive descriptions may be omitted or simplified.

Referring to FIG. 20, a via insulating layer VIA‴ may be located on the interlayer insulating layer ILD. The via insulating layer VIA‴ may include a flat part VIA-F‴ and a protruding part VIA-P. The flat part VIA-F‴ of the via insulating layer VIA‴ may be located on the driving element TR. For example, the flat part VIA-F‴ of the via insulating layer VIA‴ may be a part in contact with the source electrode SE and the drain electrode DE. For example, the flat part VIA-F‴ of the via insulating layer VIA‴ may be a part in contact with the interlayer insulating layer ILD.

The flat part VIA-F‴ of the via insulating layer VIA‴ may define a first cutout portion COF1". For example, the first cutout portion COF1" may be a portion obtained by removing at least a portion of the flat part VIA-F‴ of the via insulating layer VIA‴ from an upper surface of the flat part VIA-F‴ of the via insulating layer VIA"'. The second cutout portion COF2" may at least partially overlap a first protrusion part PDL-P1' of the pixel-defining layer PDL' in the plan view.

The pixel-defining layer PDL' may be located on the via insulating layer VIA"'. The pixel-defining layer PDL' may fill at least a portion of the first cutout portion COFL". For example, the pixel-defining layer PDL' may entirely fill the first cutout portion COF1". The pixel-defining layer PDL' may cover a side portion of the pixel electrode PE.

In one or more embodiments, the pixel-defining layer PDL' may define a transmitting part TU and an opening OP. The opening OP may be located in the second auxiliary pixel area SPX2. At least a portion of the upper surface of the pixel electrode PE may be exposed through the opening OP. The transmitting part TU may be located in the transmitting area TA. At least a portion of the via insulating layer VIA‴ may be exposed through the transmitting part TU. For example, the protrusion part VIA-P of the via insulating layer VIA‴ may be exposed through the transmitting part TU.

In one or more embodiments, the pixel-defining layer PDL' may include a flat part PDL-F', a first protruding part PDL-P1', and a second protruding part PDL-P2. For example, the flat part PDL-F' of the pixel-defining layer PDL' may be a part is in contact with the pixel electrode PE. For example, the flat part PDL-F' of the pixel-defining layer PDL' may be a part that is located on the via insulating layer VIA‴ and that is in contact with the via insulating layer VIA‴.

The first protrusion part PDL-P1' of the pixel-defining layer PDL' may be a part protruding from an upper surface of the flat part PDL-F' of the pixel-defining layer PDL' in a thickness direction of the pixel-defining layer PDL'. For example, the first protrusion part PDL-P1' of the pixel-defining layer PDL' may be a part protruding from the upper surface of the flat part PDL-F' of the pixel-defining layer PDL' adjacent to the transmitting part TU in the thickness direction of the pixel-defining layer PDL'. For example, the first protrusion part PDL-P1' of the pixel-defining layer PDL' may be a part protruding in the third direction DR3 from the upper surface of the flat part PDL-F' of the pixel-defining layer PDL' adjacent to the transmitting part TU. In one or more embodiments, the first protrusion part PDL-P1' of the pixel-defining layer PDL' may surround at least a portion of the transmitting part TU (e.g., in plan view).

The second protrusion part PDL-P2 of the pixel-defining layer PDL' may be a part protruding from the upper surface of the flat part PDL-F' of the pixel-defining layer PDL' in the thickness direction of the pixel-defining layer PDL'. For example, the second protrusion part PDL-P2 of the pixel-defining layer PDL' may be a part protruding from the upper surface of the flat part PDL-F' of the pixel-defining layer PDL' adjacent to the opening OP in the thickness direction of the pixel-defining layer PDL'. For example, the second protruding part PDL-P2 of the pixel-defining layer PDL' may be a part protruding in the third direction DR3 from the upper surface of the flat part PDL-F' of the pixel-defining layer PDL' adjacent to the opening OP. In one or more embodiments, the second flat part PDL-P2 of the pixel-defining layer PDL' may surround at least a portion of the opening OP (e.g., in plan view).

In one or more embodiments, the pixel-defining layer PDL' may define a second cutout portion COF2'. The second cutout portion COF2' may be a portion obtained by removing at least a portion of the pixel-defining layer PDL' from an upper surface of the pixel-defining layer PDL'.

The first protrusion part PDL-P1' of the pixel-defining layer PDL' may define the second cutout portion COF2'. For example, the second cutout portion COF2' may be a portion obtained by removing at least a portion of the first protrusion part PDL-P1' of the pixel-defining layer PDL' from an upper surface thereof.

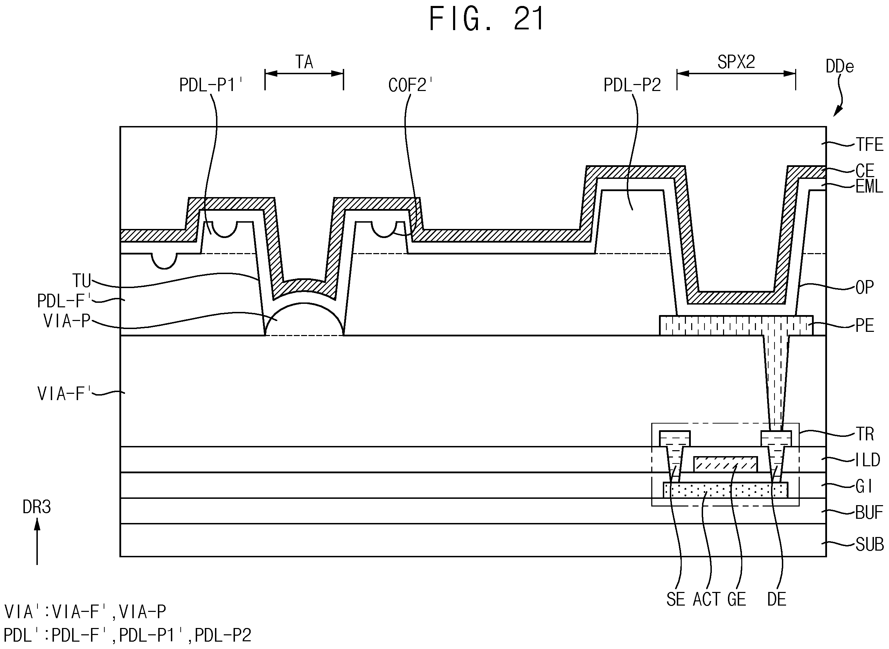

FIG. 21 is a cross-sectional view illustrating a display device according to one or more other embodiments.

A display device DDe according to one or more other embodiments described with reference to FIG. 21 may be substantially the same as or similar to the display device DDd according to one or more other embodiments described with reference to FIG. 20 except for A configuration of the via insulating layer VIA'. Therefore, overlapping or repetitive descriptions may be omitted or simplified.

Referring to FIG. 21, a via insulating layer VIA' may be located on the interlayer insulating layer ILD. The via insulating layer VIA' may include a flat part VIA-F' and a protruding part VIA-P. The flat part VIA-F' of the via insulating layer VIA' may be located on the driving element TR. For example, the flat part VIA-F" of the via insulating layer VIA' may be a part in contact with the source electrode SE and the drain electrode DE. For example, the flat part VIA-F" of the via insulating layer VIA' may be a part in contact with the interlayer insulating layer ILD. The flat part VIA-F" of the via insulating layer VIA' may not define the first cutout portion COF1 formed in the via insulating layer VIA included in the display device DDa of FIG. 2.

The protrusion part VIA-P of the via insulating layer VIA' may be a part protruding from the flat part VIA-F" of the via insulating layer VIA'. For example, the protrusion part VIA-P of the via insulating layer VIA' may be a part protruding from the upper surface of the flat part VIA-F' of the via insulating layer VIA' in a thickness direction of the via insulating layer VIA'. For example, the protrusion part VIA-P of the via insulating layer VIA' may be a part protruding from the upper surface of the flat part VIA-F" of the via insulating layer VIA' in the third direction DR3.

The pixel-defining layer PDL' may be located on the via insulating layer VIA'.

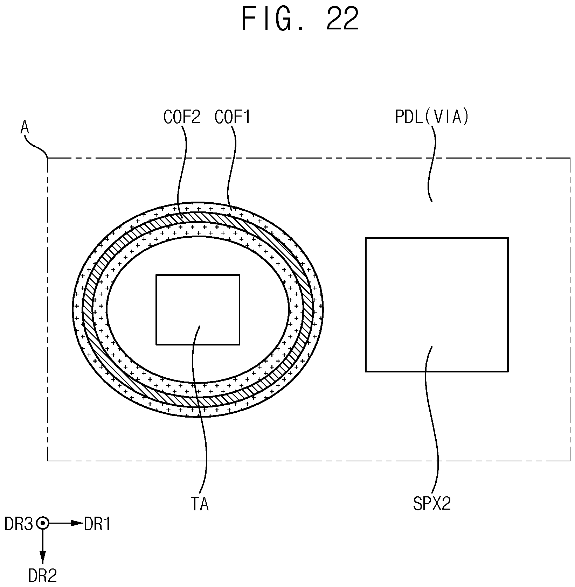

FIG. 22 is an enlarged plan view illustrating another example of an area A of FIG. 1.

Referring to FIG. 22, in one or more other embodiments, the first cutout portion COF1 may have a circular ring shape surrounding the transmitting area TA. In addition, the second cutout portion COF2 may have a circular ring shape surrounding the transmitting area TA. The second cutout portion COF2 may at least partially overlap the first cutout portion COF1 in the plan view. The second cutout portion COF2 may be located inside an area where the first cutout portion COF1 is located in the plan view. However, this invention is not limited thereto, and the second cutout portion COF2 may only partially overlap the first cutout portion COF1 in the plan view. That is, a portion of the second cutout portion COF2 may overlap the first cutout portion COF1 in the plan view, and another portion of the second cutout portion COF2 may not overlap the first cutout portion COF1 in the plan view.

The present invention can be applied to various display devices. For example, the present invention is applicable to various display devices, such as display devices for vehicles, ships and aircraft, portable communication devices, display devices for exhibition or information transmission, medical display devices, and/or the like.

The foregoing is illustrative of embodiments and is not to be construed as limiting thereof. Although some embodiments have been described, those skilled in the art will readily appreciate that many modifications are possible in the embodiments without materially departing from the novel teachings and advantages of the present inventive concept. Accordingly, all such modifications are intended to be included within the scope of the present inventive concept as defined in the claims. Therefore, it is to be understood that the foregoing is illustrative of various embodiments and is not to be construed as limited to the specific embodiments disclosed, and that modifications to the disclosed embodiments, as well as other embodiments, are intended to be included within the scope of the appended claims.

## Claims

1. A display device (DD) comprising:
a substrate (SUB) comprising an auxiliary pixel area (SPX2), and a transmitting area (TA) spaced from the auxiliary pixel area (SPX2),
a driving element (TR) above the substrate (SUB),
an insulating layer (VIA) above the driving element (TR),
an electrode (PE) in the auxiliary pixel area (SPX2), above the insulating layer (VIA), and electrically connected to the driving element (TR), and
a pixel-defining layer (PDL) above the insulating layer (VIA), defining an opening (OP) in the auxiliary pixel area (SPX2), defining a transmitting part (TU) in the transmitting area (TA), and defining a pixel-defining layer cutout portion (COF2) spaced from the auxiliary pixel area (SPX2) and the transmitting area (TA) in plan view.

2. A display device (DD) comprising
a substrate (SUB) comprising an auxiliary pixel area (SPX2), and a transmitting area (TA) spaced from the auxiliary pixel area (SPX2),
a driving element (TR) above the substrate (SUB),
an insulating layer (VIA) comprising an insulating layer flat part (VIA-F) above the driving element (TR), and an insulating layer protrusion part (VIA-P) protruding in a thickness direction from an upper surface of the insulating layer flat part (VIA-F) in the transmitting area (TA),
an electrode (PE) in the auxiliary pixel area (SPX2) above the insulating layer (VIA), and electrically connected to the driving element (TR), and
a pixel-defining layer (PDL) above the insulating layer (VIA), defining an opening (OP) in the auxiliary pixel area (SPX2), and defining a transmitting part (TU) in the transmitting area (TA).

3. The display device (DD) of claim 2, wherein the pixel-defining layer (PDL) defines a pixel-defining layer cutout portion (COF2) spaced from the auxiliary pixel area (SPX2) and the transmitting area (TA) in plan view.

4. The display device (DD) of at least one of claims 1 to 3, wherein the pixel-defining layer cutout portion (COF2) is a portion of the pixel-defining layer (PDL) removed from an upper surface thereof.

5. The display device (DD) of at least one of claims 1 to 4, wherein the pixel-defining layer cutout portion (COF2) surrounds at least a portion of the transmitting part (TU) in plan view.

6. The display device (DD) of at least one of claims 1 to 5, wherein the insulating layer (VIA) defines an insulating layer cutout portion (COF1) spaced from the auxiliary pixel area (SPX2) and the transmitting area (TA) in plan view, and
wherein the pixel-defining layer (PDL) fills at least a portion of the insulating layer cutout portion (COF1).

7. The display device (DD) of claim 6, wherein the insulating layer cutout portion (COF1) at least partially overlaps the pixel-defining layer (PDL) cutout portion (COF2) in plan view.

8. The display device (DD) of claim 6 or 7, wherein the insulating layer cutout portion (COF1) surrounds at least a portion of the transmitting part (TU) in plan view.

9. The display device (DD) of claim 6, 7 or 8, wherein the insulating layer cutout portion (COF1) is a portion of the insulating layer (VIA) removed from an upper surface thereof.

10. The display device (DD) of at least one of claims 1 to 9, wherein the pixel-defining layer (PDL) comprises:
a pixel-defining layer flat part (PDL-F) above the insulating layer (VIA); and
a first pixel-defining layer protrusion part (PDL-P1) protruding in a thickness direction from an upper surface of the pixel-defining layer flat part (PDL-F) adjacent to the transmitting part (TU).

11. The display device (DD) of claim 10, wherein the pixel-defining layer cutout portion (COF2) is defined in the first pixel-defining layer protrusion part (PDL-P1).

12. The display device (DD) of claim 10, wherein the pixel-defining layer cutout portion (COF2) is defined in the pixel-defining layer flat part (PDL-F).

13. The display device (DD) of at least one of claims 1 to 12, wherein the pixel-defining layer (PDL) comprises:
a pixel-defining layer flat part (PDL-F) above the insulating layer (VIA); and
a second pixel-defining layer protrusion part (PDL-P2) protruding in a thickness direction from an upper surface of the flat part adjacent to the opening (OP).

14. The display device (DD) of at least one of claims 1 to 13, wherein, measured from an upper surface of the insulating layer (VIA), a thickness (T3) of a portion of the pixel-defining layer (PDL) spaced from the pixel-defining layer cutout portion (COF2) in plan view is greater than a thickness (T2) of a portion of the pixel-defining layer (PDL) overlapping the pixel-defining layer cutout portion (COF2)

15. A method of manufacturing a display device (DD), especially a display device (DD) according to at least one of claims 1 to 14, the method comprising
forming a driving element (TR) above a substrate (SUB), the substrate (SUB) comprising an auxiliary pixel area (SPX2), and a transmitting area (TA) spaced from the auxiliary pixel area (SPX2),
forming an insulating layer (VIA) above the driving element (TR),
forming a preliminary pixel-defining layer (PPDL) above the insulating layer (VIA),
placing a first mask (MK2) comprising a light-blocking area (BL) overlapping the transmitting area (TA) and the auxiliary pixel area (SPX2) above the preliminary pixel-defining layer (PPDL), and
forming a pixel-defining layer (PDL) defining an opening (OP) in the auxiliary pixel area (SPX2), defining a transmitting part (TU) in the transmitting area (TA), and defining a pixel-defining layer cutout portion (COF2) spaced from the auxiliary pixel area (SPX2) and the transmitting area (TA) in plan view by exposing and developing the preliminary pixel-defining layer (PPDL) through the first mask (MK2).

16. The method of claim 15, further comprising forming an insulating layer cutout portion (COF1) spaced from the auxiliary pixel area (SPX2) and the transmitting area (TA) in plan view in the insulating layer (VIA).

17. The method of claim 16, wherein the pixel-defining layer cutout portion (COF2) and the insulating layer cutout portion (COF1) at least partially overlap, and
the pixel-defining layer cutout portion (COF2) is formed as the preliminary pixel-defining layer (PPDL) fills the insulating layer cutout portion (COF1).

18. The method of at least one of claims 15 to 17, wherein the forming the insulating layer (VIA) comprises forming an insulating layer flat part (VIA-F) above the driving element (TR), and an insulating layer protrusion part (VIA-P) protruding from an upper surface of the insulating layer flat part (VIA-F) in a thickness direction in the transmitting area (TA).

19. The method of at least one of claims 15 to 18, wherein the forming the insulating layer (VIA) comprises:
forming a preliminary insulating layer (PVIA) above the driving element (TR);
forming a photoresist layer (PR) above the preliminary insulating layer (PVIA); and
placing a second mask (MK1) comprising a light-transmitting area (TM), and a semi-light-transmitting area (HF) above the photoresist layer (PR).

20. The method of claims 18 and 19, wherein the light-transmitting area (TM) of the second mask (MK1) overlaps the insulating layer protrusion part (VIA-P) in plan view, and
wherein the semi-light-transmitting area (HF) of the second mask (MK1) is spaced from the insulating layer protrusion part (VIA-P) in plan view.

21. The method of at least one of claims 15 to 20, wherein the pixel-defining layer cutout portion (COF2) overlaps the light-blocking area (BL) of the first mask (MK2).
